# EUROPEAN PATENT APPLICATION

(11) **EP 4 657 708 A1**
(43) Date of publication of application: **03.12.2025**
(21) Application number: 25178868.3
(22) Date of filing: 26.05.2025
(51) Int. Cl.: H02J 7/00, H02J 50/90

(54) **CHARGER DETECTION METHOD FOR A USER COMPUTING DEVICE**

(30) Priority: 28.05.2024 US 202418675842
(71) Applicant: Google LLC, Mountain View, CA 94043 (US)
(72) Inventor: Clewell, Zachary Sloane, Mountain View, 94043 (US); Rao, Kishore Baikady, Mountain View, 94043 (US); Wimmer, Matthew Edward, Mountain View, 94043 (US)
(74) Representative: Maikowski & Ninnemann Patentanwälte Partnerschaft mbB

(57) **Abstract**

A user computing device includes one or more first sensors that output one or more first signals based on a magnetic field measured via the one or more first sensors and one or more processors configured to execute instructions to perform operations. The operations include detecting whether the user computing device is receiving a charge from a charging device. When the user computing device is not receiving the charge, the operations include determining, based on the one or more first signals output by the one or more first sensors, whether the user computing device is proximate to the charging device, and when the user computing device is determined, based on the one or more first signals output by the one or more first sensors, to be proximate to the charging device, providing an output indicating the user computing device is not receiving the charge.

## Description

### FIELD

The disclosure relates generally to a charger detection method for user computing devices which can be charged via a charging device. More particularly, the disclosure relates to a charger detection method for a wearable computing device based on a magnetic field measured by a sensor device provided to the wearable computing device.

### BACKGROUND

Existing charging devices (e.g., a charging puck) can provide a charging current to a user computing device. In some instances, a user may incorrectly couple a user computing device to a charging device, or believe that the user computing device is receiving a charge but the user computing device is inadvertently not connected to power, resulting in the user computing device not being charged.

### SUMMARY

Aspects and advantages of embodiments of the disclosure will be set forth in part in the following description, or can be learned from the description, or can be learned through practice of the example embodiments.

In an example embodiment, a user computing device (e.g., a wearable computing device, a smartphone, etc.) is provided. The user computing device includes one or more first sensors configured to output one or more first signals based on a magnetic field measured via the one or more first sensors; one or more memories configured to store instructions; and one or more processors configured to execute the instructions to perform operations, the operations comprising: detecting whether the user computing device is receiving a charge from a charging device, when the user computing device is not receiving the charge, determining, based on the one or more first signals output by the one or more first sensors, whether the user computing device is proximate to the charging device, and when the user computing device is determined, based on the one or more first signals output by the one or more first sensors, to be proximate to the charging device, providing an output indicating the user computing device is not receiving the charge.

In some implementations, the user computing device includes one or more second sensors configured to output one or more second signals indicating a movement associated with the user computing device measured via the one or more second sensors, and the operations further comprise when the user computing device is not receiving the charge and the one or more second signals indicate the movement associated with the user computing device is less than a threshold movement level, determining, based on the one or more second signals output by the one or more second sensors, whether the user computing device is proximate to the charging device.

In some implementations, the user computing device includes one or more third sensors configured to output one or more third signals indicating whether the user computing device is worn on a body part of a user, and the operations further comprise, when the user computing device is not receiving the charge and the one or more third signals indicate the user computing device is not worn on the body part of the user, changing a sampling rate of the one or more first sensors from a first sampling rate to a second sampling rate, wherein the second sampling rate is greater than the first sampling rate.

In some implementations, the operations include maintaining the second sampling rate for a threshold duration of time.

In some implementations, the operations include, after the threshold duration of time elapses, changing the sampling rate from the second sampling rate to the first sampling rate.

In some implementations, the operations include, in response to providing the output indicating the user computing device is not receiving the charge, changing a sampling rate of the one or more first sensors from a first sampling rate to a second sampling rate, the second sampling rate being less than the first sampling rate.

In some implementations, the operations include, after a threshold duration of time has elapsed after providing the output indicating the user computing device is not receiving the charge, changing a sampling rate of the one or more first sensors from a first sampling rate to a second sampling rate, the second sampling rate being less than the first sampling rate.

In some implementations, the operations include, after providing the output indicating the user computing device is not receiving the charge and in response to the one or more processors detecting the user computing device is receiving the charge, changing a sampling rate of the one or more first sensors from a first sampling rate to a second sampling rate, the second sampling rate being less than the first sampling rate.

In some implementations, the user computing device includes one or more second sensors configured to output one or more second signals indicating whether the user computing device is worn on a body part of a user, and the operations further include: after providing the output indicating the user computing device is not receiving the charge and in response to the one or more second signals indicating the user computing device is worn on the body part of the user, changing a sampling rate of the one or more first sensors from a first sampling rate to a second sampling rate, the second sampling rate being less than the first sampling rate.

In some implementations, the output includes at least one of haptic feedback, audio feedback, or a visual representation on a display device of the user computing device, indicating the user computing device is not receiving the charge.

In some implementations, the output includes transmitting a communication to an external computing device indicating the user computing device is not receiving the charge.

In some implementations, the operations include limiting the number of times the output indicating the user computing device is not receiving the charge is provided to a threshold number of times within a threshold duration of time.

In some implementations, the output indicating the user computing device is not receiving the charge is maintained for a threshold duration of time irrespective of whether the user computing device makes a different determination regarding whether the user computing device is proximate to the charging device within the threshold duration of time.

In some implementations, the one or more first sensors include one or more magnetometers, and the one or more processors are configured to: determine at least one magnitude value based on the one or more first signals, determine whether the at least one magnitude value satisfies a threshold magnitude value, and when the at least one magnitude value satisfies the threshold magnitude value, determining the user computing device is proximate to the charging device.

In some implementations, the at least one magnitude value includes a maximum magnitude value among a plurality of magnitude values sampled during a predetermined duration of time.

In some implementations, the one or more first sensors include one or more magnetometers, and the one or more processors are configured to: determine at least one magnitude range value based on the one or more first signals, wherein the at least one magnitude range value includes a difference between a maximum magnitude value among a plurality of magnitude values sampled during a predetermined duration of time and a minimum magnitude value among the plurality of magnitude values sampled during the predetermined duration of time, determine whether the at least one magnitude range value satisfies a threshold magnitude range value, and when the at least one magnitude range value satisfies the threshold magnitude range value, determining the user computing device is proximate to the charging device.

In some implementations, the one or more first sensors include one or more magnetometers configured to measure the magnetic field with respect to a plurality of axes, and the one or more processors are configured to: determine at least one magnitude range value for each of the plurality of axes based on the one or more first signals, wherein the at least one magnitude range value includes a difference between a maximum magnitude value among a plurality of magnitude values sampled during a predetermined duration of time and a minimum magnitude value among the plurality of magnitude values sampled during the predetermined duration of time, determine whether at least one of the at least one magnitude range values determined for each of the plurality of axes satisfies a threshold magnitude range value, and when at least one of the at least one magnitude range values determined for each of the plurality of axes satisfies the threshold magnitude range value, determining the user computing device is proximate to the charging device.

In some implementations, the one or more first sensors include one or more magnetometers, and the one or more processors are configured to: determine magnitude values based on the one or more first signals over a predetermined duration of time, determine, for each of a plurality of intervals of time over the predetermined duration of time, whether at least one magnitude value from each interval among the plurality of intervals satisfies a threshold magnitude value, when the threshold magnitude value is satisfied for a threshold number of intervals among the plurality of intervals, determining the user computing device is proximate to the charging device.

In an example embodiment, a computer-implemented method is provided. The computer-implemented method includes: detecting, by one or more processors of a user computing device, whether the user computing device is receiving a charge from a charging device; and when the user computing device is not receiving the charge: outputting one or more first signals based on a magnetic field measured via one or more first sensors of the user computing device, determining, based on the one or more first signals output by the one or more first sensors, whether the user computing device is proximate to the charging device, and when the user computing device is determined, based on the one or more first signals output by the one or more first sensors, to be proximate to the charging device, providing an output indicating the user computing device is not receiving the charge.

The computer-implemented method may execute any of the operations of the user computing device as described herein.

In an example embodiment, a non-transitory computer-readable medium which stores instructions that are executable by one or more processors of a computing device is provided. The non-transitory computer-readable medium stores instructions which are executable by one or more processors of the computing device. The instructions include: detecting whether the user computing device is receiving a charge from a charging device; and when the user computing device is not receiving the charge: receiving one or more first signals based on a magnetic field measured via one or more first sensors of the user computing device, determining, based on the one or more first signals output by the one or more first sensors, whether the user computing device is proximate to the charging device, and when the user computing device is determined, based on the one or more first signals output by the one or more first sensors, to be proximate to the charging device, providing an output indicating the user computing device is not receiving the charge.

The non-transitory computer-readable medium may store additional instructions to execute other aspects and operations of the user computing device and computer-implemented method as described herein.

These and other features, aspects, and advantages of various embodiments of the disclosure will become better understood with reference to the following description, drawings, and appended claims. The accompanying drawings, which are incorporated in and constitute a part of this specification, illustrate examples of the disclosure and, together with the description, serve to explain the related principles.

### BRIEF DESCRIPTION OF THE DRAWINGS

Detailed discussion of example embodiments directed to one of ordinary skill in the art is set forth in the specification, which makes reference to the appended drawings, in which:
FIGS. 1A-1D are example diagrams of a charging system (e.g., including a user computing device and charging device), according to one or more examples of the disclosure;
FIG. 2 is an illustration of an example charging system, according to one or more examples of the disclosure;
FIGS. 3A and 3B are example signals output by the magnetometer when provided near or proximate to a charging device, according to examples of the disclosure;
FIGS. 4 through 6 are example sequence diagrams of charger detection processes, according to examples of the disclosure; and
FIG. 7 is a flow diagram of an example, non-limiting computer-implemented method according to one or more examples of the disclosure.

### DETAILED DESCRIPTION

Reference now will be made to embodiments of the disclosure, one or more examples of which are illustrated in the drawings. Each example is provided by way of explanation of the disclosure and is not intended to limit the disclosure. In fact, it will be apparent to those skilled in the art that various modifications and variations can be made to the disclosure without departing from the scope or spirit of the disclosure. For instance, features illustrated or described as part of one embodiment can be used with another embodiment to yield a still further embodiment. Thus, it is intended that the disclosure covers such modifications and variations as come within the scope of the appended claims and their equivalents.

Terms used herein are used to describe the example embodiments and are not intended to limit and / or restrict the disclosure. The singular forms "a," "an" and "the" are intended to include the plural forms as well, unless the context clearly indicates otherwise. In this disclosure, terms such as "including", "having", "comprising", and the like are used to specify features, numbers, steps, operations, elements, components, or combinations thereof, but do not preclude the presence or addition of one or more of the features, elements, steps, operations, elements, components, or combinations thereof.

It will be understood that, although the terms first, second, third, etc., may be used herein to describe various elements, the elements are not limited by these terms. Instead, these terms are used to distinguish one element from another element. For example, without departing from the scope of the disclosure, a first element may be termed as a second element, and a second element may be termed as a first element.

The term "and / or" includes a combination of a plurality of related listed items or any item of the plurality of related listed items. For example, the scope of the expression or phrase "A and/or B" includes the item "A", the item "B", and the combination of items "A and B".

In addition, the scope of the expression or phrase "at least one of A or B" is intended to include all of the following: (1) at least one of A, (2) at least one of B, and (3) at least one of A and at least one of B. Likewise, the scope of the expression or phrase "at least one of A, B, or C" is intended to include all of the following: (1) at least one of A, (2) at least one of B, (3) at least one of C, (4) at least one of A and at least one of B, (5) at least one of A and at least one of C, (6) at least one of B and at least one of C, and (7) at least one of A, at least one of B, and at least one of C.

In some instances, users of a user computing device (e.g., a wearable computing device, a smartphone, etc.), have issues or problems correctly coupling their user computing device to a charging device (e.g., a charging puck). Or in some instances, the user may correctly couple their user computing device to the charging device, but the charging device is not connected to power (e.g., it is inadvertently unplugged). Therefore, the user computing device may not be charged despite a user's intention to charge their device, resulting in reduced uptime and increased user inconvenience.

Accordingly, one or more aspects of the disclosure are directed to methods for detecting whether the user computing device is coupled to the charging device and receiving a charge. Further, in some implementations aspects of the disclosure are directed to methods for alerting or notifying the user when the user computing device is not coupled to the charging device or is not receiving a charge despite an indication that the user intended to couple the user computing device to the charging device and to receive a charge.

According to examples of the disclosure, the user computing device includes one or more first sensors (e.g., a magnetometer) which are configured to detect whether the user computing device is near (proximate to) the charging device. In some implementations, the one or more first sensors include a magnetometer which is configured to measure a magnetic field associated with magnets which are provided in the charging device. The magnetic field measured by the magnetometer may include particular features or characteristics (e.g., a particular noise level, a particular variance in the noise level, etc.). For example, if the magnetometer outputs a signal having the particular features or characteristics (representative of a user computing device being near or proximate to a charging device), but the user computing device does not receive a charge from the charging device, the user computing device may be configured to provide an output (e.g., a message, haptic feedback, audio, etc.), indicating that the user computing device is not receiving a charge.

In some implementations, the user computing device is configured to determine whether the user computing device is being worn on a body part of a user. If the user computing device is removed from a body part of a user, a charger detection process can begin for a predetermined duration of time to determine whether the user computing device is near (proximate to) the charging device, for example, based on a signal output by the magnetometer.

In some implementations, the user computing device is configured to determine whether movement of the user computing device exceeds a threshold movement level. For example, if the user computing device is removed from a body part of a user and exceeds the threshold movement level, the charger detection process can be delayed until the movement of the user computing device is below the threshold movement level. For example, an aspect of the charger detection process may include setting a timer for a predetermined duration of time and/or increasing a sampling rate of the magnetometer.

Example aspects of the disclosure provide several technical effects, benefits, and/or improvements in computing technology and the technology of computing devices and health monitoring devices. For example, according to one or more examples of the disclosure, a user computing device can detect (infer, determine, etc.), that is near a charging device, but is not receiving a charge. An output can be provided to a user to alert or notify the user that the user computing device is not receiving a charge. The user can take corrective action to correctly couple the user computing device to the charging device, thereby increasing uptime availability of the user computing device and reducing user inconvenience.

Further, power savings may be achieved and enhanced by implementing various criteria for the sampling rate of the magnetometer to be increased and the charger detection process to be carried out. For example, the sampling rate of the magnetometer may operate at a low sampling rate (e.g., 0 Hz, 5 Hz, etc.) and not be increased unless and until the movement of the user computing device is below the threshold movement level, the user computing device is not worn on a body part of the user, and/or the user computing device is not receiving a charge.

Further, a sufficient time for allowing the user computing device to determine, via the charger detection process, whether the user computing device is near (proximate to) the charging device, while also conserving battery power, can be ensured by implementation of a timer. For example, a timer associated with the charger detection process may not start unless and until the movement of the user computing device is below the threshold movement level, the user computing device is not worn on a body part of the user, and/or the user computing device is not receiving a charge.

Therefore, aspects of the disclosure provide the technical effect, benefit, and/or improvements in computing technology and the technology of charging devices and user computing devices (e.g., wearable computing devices, smartphones, etc.) and health monitoring devices, by efficiently, safely, and reliably providing a charger detection method for a user computing device, as described herein.

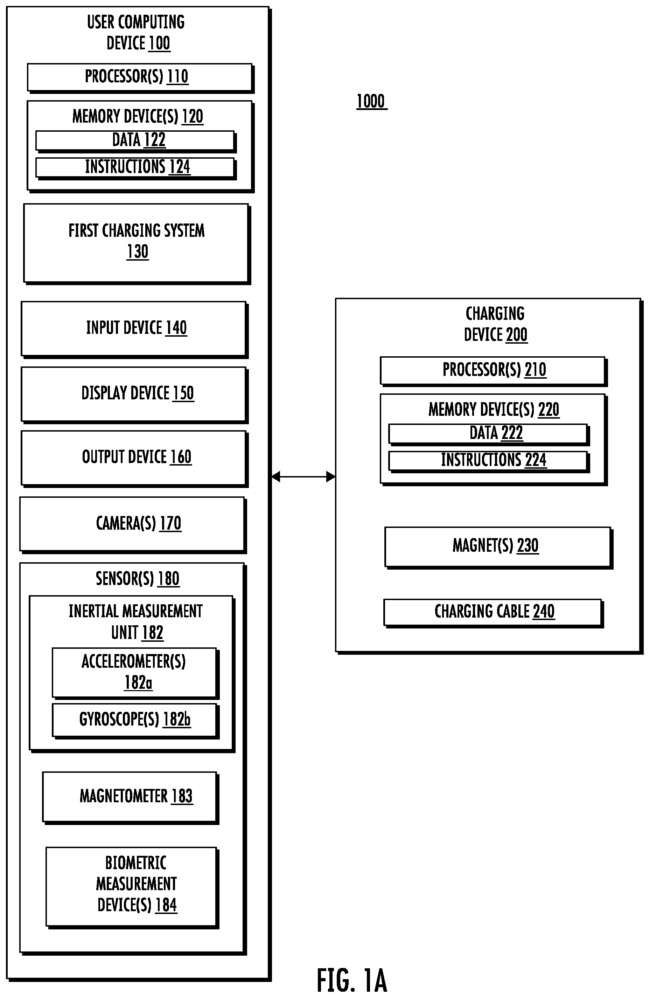

Referring now to the drawings, FIGS. 1A-1D are example diagrams of a charging system (e.g., including a user computing device and charging device), according to one or more examples of the disclosure.

In FIG. 1A, the example charging system 1000 includes a user computing device 100 and a charging device 200. For example, the user computing device 100 and charging device 200 may be coupled to or connected with one another in a wired or wireless manner (e.g., via a charging cable 240 which can enable the charging device 200 to provide a charge to a battery of the user computing device 100 and to enable the charging device 200 and user computing device 100 to exchange information with one another). Any communications interfaces suitable for communicating may be utilized as appropriate or desired by the user computing device 100 and charging device 200.

The user computing device 100 may include a wearable computing device and may include a smart band, a smart watch, a smart patch, smart clothing, fitness tracker, and the like. In some implementations, the user computing device 100 may include a smartphone, a tablet, earbuds, etc., and other devices which can include a battery that is chargeable by a charging device according to the methods described herein. In some implementations, the user computing device 100 may include biometric measurement devices 184 including a pulse oximeter, heart rate monitor, blood pressure monitor, electrodermal activity sensor, glucometer, body temperature monitor, sleep tracker, electrocardiogram devices, and the like. The user computing device 100 may be configured to measure various biometrics, including biometrics associated with an electrocardiogram (ECG), photoplethysmogram (PPG), heart rate, pulse information, BMI, heart rate variability, blood pressure, oxygen saturation, body temperature, sleep quality, physical activities (e.g., number of steps walked), and the like. Further, in some implementations the user computing device 100 may be configured to generate biometric information associated with an electrocardiogram, a photoplethysmogram, heart rate, blood pressure, oxygen saturation, respiration rate, body temperature, physical activity, a sleep metric, electrical conductance, and the like.

The charging device 200 may include a charging cable 240 (e.g., a USB charging cable, for example, a USB type-C charging cable) that is connectable or couplable at one end to a device having a charging port (e.g., a charging adapter, a wall charger, charging station etc.), and connectable or couplable at another end to a computing device (e.g., the user computing device 100). The charging cable 240 can receive power via the device having the charging port so that power can then be provided to the user computing device 100 (e.g., via connector pins).

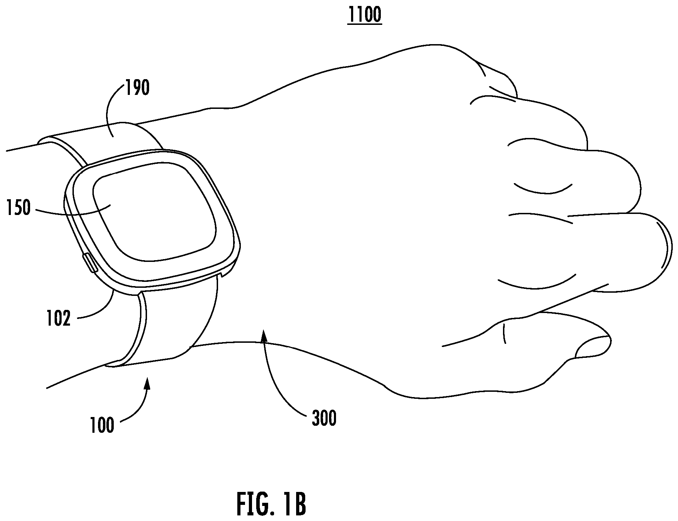

Referring to FIG. 1B, according to some implementations of the disclosure, in the illustrated overview 1100 the user computing device 100 may correspond to a wearable computing device (e.g., a smartwatch) that can be worn by a user 300. For example, the front side of the user computing device 100 can include the display device 150 and include a fastener 190 (band) configured to secure the user computing device 100 to the user 300. For example, the fastener 190 may be connectable or couplable to a body 102 of the user computing device 100.

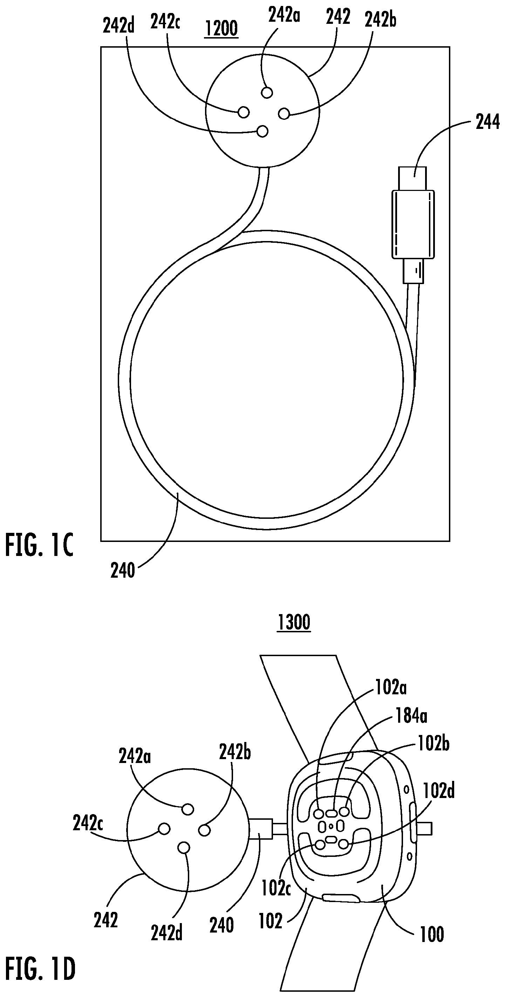

Referring to FIG. 1C, according to some implementations of the disclosure, in the illustrated overview 1200 the charging device 200 includes the charging cable 240. For example, the charging cable 240 can include a first end 242 having a plurality of pins (e.g., a first pin 242a, a second pin 242b, a third pin 242c, and a fourth pin 242d) which can include a voltage or power line and a ground line, and can be configured to deliver power and data to the user computing device 100, for example. The example of FIG. 1C shows a charging device 200 having four pins, however the disclosure is not limited to this example, and the charging device 200 may have more or less than four pins. In some implementations, the plurality of pins may be magnetic or have magnetic properties. For example, the charging cable 240 can include a second end 244 which is connectable or couplable to a device having a charging port (e.g., a charging adapter, a wall charger, charging station etc.). It is noted that FIG. 1C is merely an example charging device and that the disclosure is not limited to the charging device 200 of FIG. 1C. For example, in some implementations the charging device 200 may not include any pins.

Referring to FIG. 1D, according to some implementations of the disclosure, in the illustrated overview 1300 the user computing device 100 can include a plurality of ports or contacts (e.g., a first port 102a, a second port 102b, a third port 102c, and a fourth port 102d) which can be configured to receive the power and the data delivered from the charging cable 240 via the plurality of pins (e.g., the first pin 242a, the second pin 242b, the third pin 242c, and the fourth pin 242d). The example of FIG. 1D shows a user computing device 100 having four ports or contacts, however the disclosure is not limited to this example, and the user computing device 100 may have more or less than four ports or contacts. For example, the plurality of ports or contacts can be provided on a rear side of the body 102 of the user computing device 100 and may be provided proximate or adjacent to a plurality of biometric sensors which are also provided on the rear side of the user computing device 100 (e.g., PPG sensors 184a). As an example implementation, the plurality of pins provided at the first end 242 of the charging cable 240 may be aligned with the plurality of ports or contacts for the charging device 200 to charge the user computing device 100. In some implementations, an orientation at the interface between the plurality of pins and the plurality of ports or contacts can be reversed so that either input orientation may be recognized by the user computing device 100.

The user computing device 100 may include one or more processors 110, one or more memory devices 120, a first charging system 130, an input device 140, a display device 150, an output device 160, one or more cameras 170, and one or more sensors 180. One or more of the components of the user computing device 100 may be operatively connected with one another via a system bus. In some implementations, the user computing device 100 may include fewer or more components than that shown in FIG. 1A. For example, the user computing device 100 may not include the display device 150. For example, the system bus may be any of several types of bus structures that may further interconnect to a memory bus (with or without a memory controller), a peripheral bus, and/or a local bus using any of a variety of commercially available bus architectures.

The charging device 200 may include one or more processors 210, one or more memory devices 220, one or more magnets 230, and a charging cable 240. One or more of the features of the charging device 200 may be operatively connected with one another via a system bus. For example, the system bus may be any of several types of bus structures that may further interconnect to a memory bus (with or without a memory controller), a peripheral bus, and/or a local bus using any of a variety of commercially available bus architectures.

For example, the one or more processors 110, 210 can be any suitable processing device that can be included in a user computing device 100 or charging device 200. For example, such a processor 110, 210 may include one or more of a processor, processor cores, a controller and an arithmetic logic unit, a central processing unit (CPU), a graphics processing unit (GPU), a digital signal processor (DSP), an image processor, a microcomputer, a field programmable array, a programmable logic unit, an application-specific integrated circuit (ASIC), a microprocessor, a microcontroller, etc., and combinations thereof, including any other device capable of responding to and executing instructions in a defined manner. The one or more processors 110, 210 can be a single processor or a plurality of processors that are operatively connected, for example in parallel.

The one or more memory devices 120, 220 can include one or more non-transitory computer-readable storage mediums, such as such as a Read Only Memory (ROM), Programmable Read Only Memory (PROM), Erasable Programmable Read Only Memory (EPROM), and flash memory, a USB drive, a volatile memory device such as a Random Access Memory (RAM), an internal or external hard disk drive (HDD), floppy disks, a blu-ray disk, or optical media such as CD ROM discs and DVDs, and combinations thereof. However, examples of the one or more memory devices 120, 220 are not limited to the above description, and the one or more memory devices 120, 220 may be realized by other various devices and structures as would be understood by those skilled in the art.

For example, the one or more memory devices 120 can store instructions, that when executed, cause the one or more processors 110 to perform operations including: detecting whether the user computing device 100 is receiving a charge from the charging device 200; and when the user computing device 100 is not receiving the charge: receiving one or more first signals based on a magnetic field measured via one or more sensors 180 (e.g., first sensors) of the user computing device 100, determining, based on the one or more first signals output by the one or more sensors 180 (e.g., firs sensors), whether the user computing device 100 is proximate to the charging device 200, and when the user computing device 100 is determined, based on the one or more first signals output by the one or more sensors 180 (e.g., first sensors), to be proximate to the charging device 200, providing an output indicating the user computing device 100 is not receiving the charge, as described according to examples of the disclosure.

The one or more memory devices 120 can also include data 122 and instructions 124 that can be retrieved, manipulated, created, or stored by the one or more processors 110. In some examples, such data can be accessed and used as input to perform operations including: detecting whether the user computing device 100 is receiving a charge from the charging device 200; and when the user computing device 100 is not receiving the charge: receiving one or more first signals based on a magnetic field measured via one or more sensors 180 (e.g., first sensors) of the user computing device 100, determining, based on the one or more first signals output by the one or more sensors 180 (e.g., first sensors), whether the user computing device 100 is proximate to the charging device 200, and when the user computing device 100 is determined, based on the one or more first signals output by the one or more sensors 180 (e.g., first sensors), to be proximate to the charging device 200, providing an output indicating the user computing device 100 is not receiving the charge, as described according to examples of the disclosure.

The one or more memory devices 220 can also include data 222 and instructions 224 that can be retrieved, manipulated, created, or stored by the one or more processors 210. In some examples, such data can be accessed and used as input to perform operations of the charging device, as described according to examples of the disclosure.

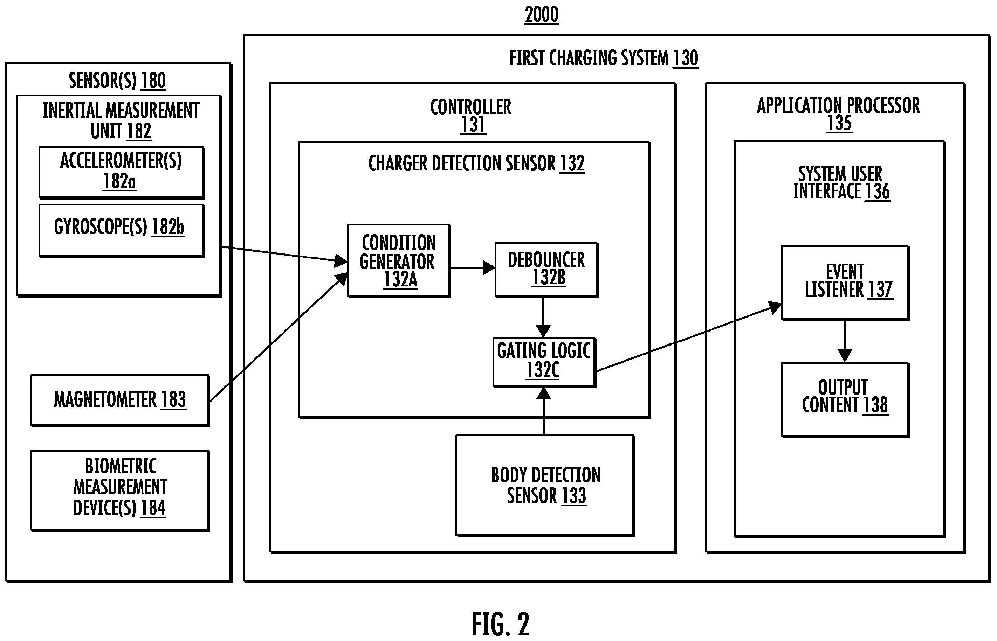

The first charging system 130 can include any charging system which allows or is capable of receiving a charge for charging a power source (e.g., a battery) of the user computing device 100. The first charging system 130 may also be configured to detect whether the user computing device 100 is properly coupled to or connected to the charging device 200. Example components and operations of the first charging system 130 are described with respect to FIG. 2 herein.

The user computing device 100 may include an input device 140 configured to receive an input from a user and may include, for example, one or more of a keyboard (e.g., a physical keyboard, virtual keyboard, etc.), a mouse, a joystick, a button, a switch, an electronic pen or stylus, a gesture recognition sensor (e.g., to recognize gestures of a user including movements of a body part), an input sound device or voice recognition sensor (e.g., a microphone to receive a voice command), a track ball, a remote controller, a portable (e.g., a cellular or smart) phone, and so on. The input device 140 may also be embodied by a touch-sensitive device or a touch-sensitive display device having a touchscreen capability. For example, the input device 140 may be used by a user of the user computing device 100 to provide an input to control a process of the charging operation of the user computing device 100. For example, the input may be a voice input, a touch input, a gesture input, a click via a mouse or remote controller, and so on.

In some implementations, the user computing device 100 may include a display device 150 which presents information viewable by the user, for example on a user interface (e.g., a graphical user interface). For example, the display device 150 may be a non-touch sensitive display. The display device 150 may include a liquid crystal display (LCD), a light emitting diode (LED) display, an organic light emitting diode (OLED) display, active matrix organic light emitting diode (AMOLED), flexible display, 3D display, a plasma display panel (PDP), a cathode ray tube (CRT) display, and the like, for example. However, the disclosure is not limited to these example display devices and may include other types of display devices. For example, the display device 150 may be configured to provide a visual representation of a status of a charging operation, to provide an indication regarding whether the user computing device 100 is correctly coupled to the charging device 200, to provide information regarding a biometric measurement, etc.

The user computing device 100 may include an output device 160 configured to provide an output to the user and may include, for example, one or more of an audio device (e.g., one or more speakers), a haptic device to provide haptic feedback to a user, a light source (e.g., one or more light sources such as LEDs which provide visual feedback to a user), the display device 150, and the like. For example, in some implementations of the disclosure the user may be provided with an output (e.g., via one or more of the speaker, haptic device, light source, display device, etc.) indicating a status of a charging operation, a status of the battery, providing an indication regarding whether the user computing device 100 is correctly coupled to the charging device 200, providing instructions to perform an operation to properly couple the user computing device 100 to the charging device 200, etc.

The user computing device 100 may include one or more cameras 170. For example, the one or more cameras 170 may include an imaging sensor (e.g., a complementary metal-oxide-semiconductor (CMOS) or charge-coupled device (CCD)) to capture, detect, or recognize a user's behavior, figure, expression, etc. In some implementations, the one or more cameras 170 may be used to detect or capture an image of the user for determining biometric information of the user.

The user computing device 100 may include one or more sensors 180. For example, the one or more sensors 180 may include an inertial measurement unit 182 which includes one or more accelerometers 182a and/or one or more gyroscopes 182b. The one or more accelerometers 182a may be used to capture motion information with respect to the user computing device 100. The one or more gyroscopes 182b may also be used additionally or alternatively to capture motion information with respect to the user computing device 100. For example, the inertial measurement unit 182 may be configured as a six-axis or six-dimensional inertial measurement unit (e.g., a tri-axial accelerometer and a tri-axial gyroscope).

The one or more sensors 180 may include one or more magnetometers 183 which can be used to measure the strength and/or direction of magnetic fields. The one or more magnetometers 183 can be configured to detect the presence of magnetic fields and may be configured to determine the direction and intensity of the Earth's magnetic field (e.g., to provide a compass feature, for navigation functions, for gesture recognition, etc.). According to examples of the disclosure, noise associated with magnetic field measurements may be used to determine whether the user computing device 100 is near or proximate to the charging device 200. While various examples described herein refer to a magnetometer which can be configured to measure the strength (magnitude) of a magnetic signal and a direction (orientation) of the magnetic field, other devices may be implemented to perform similar functions (e.g., a Hall Effect sensor).

The one or more sensors 180 may include one or more biometric measurement devices 184 which can be used to measure biometric information of a user. For example, the one or more biometric measurement devices 184 may include heart rate sensors, blood pressure sensors, ECG sensors, PPG sensors, galvanic skin sensors, blood oxygen sensors, body temperature sensors, respiration rate sensors, and the like. The inertial measurement unit 182 can also be used to measure biometric information of the user. The one or more sensors 180 may also include other sensors such as a Hall effect sensor, GPS sensor, proximity sensor, optical sensors, force sensors, and the like.

Referring to FIG. 2, an example diagram of a charging system is illustrated, according to one or more examples of the disclosure. In FIG. 2, the charging system 2000 includes the first charging system 130 and the one or more sensors 180.

In an example implementation, the first charging system 130 may include a controller 131 and an application processor 135. In some implementations, the controller 131 may include a microcontroller and may include one or more processors. In some implementations, the application processor 135 may include one or more processors and may be configured to execute an operating system, execute applications, and manage various tasks related to the user interface and functionality of the user computing device 100.

In some implementations, the controller 131 may include a charger detection sensor 132 and a body detection sensor 133. In some implementations, the charger detection sensor 132 may include a condition generator 132a, a debouncer 132b, and gating logic 132c. The application processor may include a system user interface 136. The system user interface 136 may include an event listener 137 and output content 138. The various components provided to the controller 131 and application processor 135 in FIG. 2 are example components and more or less components may be provided. Further, the various components provided to the controller 131 and application processor 135 in FIG. 2 may be provided separately (independently) or may be provided to other components of the user computing device 100.

Condition generator 132a may be configured to determine whether various conditions are satisfied with respect to determining whether the user computing device 100 is proximate to the charging device 200. For example, the conditions may include whether movement associated with the user computing device 100 is greater than a threshold movement threshold level, whether the user computing device 100 is receiving a charge, whether the user computing device 100 is placed on a body part of a user, and whether signals output by the magnetometer 183 indicate the user computing device 100 is proximate to the charging device 200.

Various methods may be implemented to determine or infer that the user computing device 100 is proximate to the charging device 200, based on the signals output by the magnetometer 183. As described herein, the one or more magnetometers 183 can be configured to measure the strength and/or direction of magnetic fields. For example, the magnetometer 183 may be configured to output a signal associated with the magnetometer data. As described herein, the charger detection sensor 132 (e.g., the condition generator 132a) may be configured to analyze the noise present in the magnetometer data when the user computing device 100 is close to a strong magnetic field to determine if the user computing device 100 is near the charging device 200. In some implementations, the condition generator 132a may be configured to analyze the noise associated with the magnetic field measurements made by the magnetometer 183 to determine whether the user computing device 100 is near or proximate to the charging device 200.

As described herein, because the noise present in the magnetometer may be easier to observe at higher frequencies, the user computing device 100 may be configured to change (increase) a sampling rate of the magnetometer 183. For example, a sampling rate of the magnetometer 183 may be increased from 0 Hz or 5 Hz to 100 Hz when the charger detection sensor 132 is implemented to determine whether the user computing device 100 is near or proximate to the charging device 200. Increasing the sampling rate of the magnetometer 183 can increase power draw considerably. In some implementations, the sampling rate of the magnetometer 183 may be increased for a predetermined duration of time (e.g., two minutes, five minutes, etc.) and then returned to the default sampling rate (e.g., 0 Hz, 5 Hz, etc.) to conserve power of the user computing device 100. In some implementations, the sampling rate may be returned to the default sampling rate in response to an input from a user (e.g., indicating that the user does not intend to charge the user computing device 100, that the user is aware (or has confirmed) of a communication indicating that the user computing device 100 is not receiving a charge but appears to be near or proximate to the charging device 200, etc.). Accordingly, battery impact can be minimized through various gating methods to set the sampling rate of the magnetometer 183 according to a particular circumstance.

For example, one or more motion sensors (e.g., the inertial measurement unit 182 including the one or more accelerometers 182a and/or one or more gyroscopes 182b) may be configured to indicate whether movement of the user computing device 100 is greater than a threshold movement level. In some implementations, the condition generator 132a may be configured to compare the magnitude of a motion vector (e.g., a magnitude of an acceleration vector) to the magnitude of the constant gravity vector (e.g., Earth's average gravity vector). If the magnitude of the motion vector differs by a threshold amount the user computing device 100 (e.g., the condition generator 132a) may be configured to determine the user computing device 100 is in motion and stop or end a process being implemented by the user computing device 100 for determining whether the user computing device 100 is near or proximate to the charging device 200.

In some implementations, if an output of the one or more motion sensors indicate (e.g., via one or more motion signals) the movement of (associated with) the user computing device 100 is greater than the threshold movement level, outputs generated via the magnetometer 183 are ignored by the condition generator 132a and no determination is made as to whether the user computing device 100 is near or proximate to the charging device 200. In some implementations, if an output of the one or more motion sensors indicate (e.g., via one or more motion signals) the movement of (associated with) the user computing device 100 is greater than the threshold movement level, the condition generator 132a may be configured to stop or prevent the user computing device 100 from implementing a process for determining whether the user computing device 100 is near or proximate to the charging device 200. In some implementations, if an output of the one or more motion sensors indicate the movement of the user computing device 100 is greater than the threshold movement level, the condition generator 132a may be configured to stop or end a process being implemented by the user computing device 100 for determining whether the user computing device 100 is near or proximate to the charging device 200. In some implementations, if an output of the one or more motion sensors indicate the movement of the user computing device 100 is less than the threshold movement level, the condition generator 132a may be configured to allow or permit the user computing device 100 to implement a process for determining whether the user computing device 100 is near or proximate to the charging device 200. In some implementations, if an output of the one or more motion sensors indicate the movement of the user computing device 100 is less than the threshold movement level, the condition generator 132a may be configured to maintain or continue a process being implemented by the user computing device 100 for determining whether the user computing device 100 is near or proximate to the charging device 200.

In some implementations, the condition generator 132a may be configured to implement the use of a sliding buffer with respect to a predetermined duration of time of magnetometer data (e.g., the last second of the magnetometer data, the last five seconds, etc.) where the magnetometer data is maintained and updated on each sample per axis. In some implementations, on every sample at least two metrics may be generated per axis: e.g., the maximum magnitude of any single sample and the difference between the minimum raw values and maximum raw values (e.g., range magnitude data).

The condition generator 132a may be configured to compare magnitude values to threshold magnitude values tuned per axis (e.g., based on experimental results) to calculate a magnitude condition. In some implementations, if any of the magnitude values exceed their axis threshold, the condition generator 132a is configured to determine the magnitude condition is satisfied (true). In some implementations, if the condition generator 132a determines the magnitude condition is satisfied, the charger detection sensor 132 (e.g., via gating logic 132c) may be configured to provide an output indicating the user computing device 100 is near or proximate to the charging device 200 (e.g., a near-charger event).

The condition generator 132a may be configured to compare range values against threshold range values tuned per axis (e.g., based on experimental results). In some implementations, if any of the range values exceed the axis threshold range value, the condition generator 132a may be configured to determine the range condition is satisfied (true). In some implementations, if the condition generator 132a determines the range condition is satisfied, the charger detection sensor 132 (e.g., via gating logic 132c) may be configured to provide an output indicating the user computing device 100 is near or proximate to the charging device 200 (e.g., a near-charger event).

In some implementations, the condition generator 132a may be configured to consider additional conditions for the range condition to be satisfied (true). For example, in addition to the condition that at least one of the range values exceed the axis threshold range value, the condition generator 132a may be required to determine that movement of the user computing device 100 is less than the threshold movement level and/or that a last event output by the user computing device 100 was a near-charger event.

In some implementations, the condition generator 132a may be configured to determine whether the magnitude condition and the range condition are satisfied. In some implementations, if the condition generator 132a determines the magnitude condition and range condition are satisfied, the charger detection sensor 132 (e.g., via gating logic 132c) may be configured to provide an output indicating the user computing device 100 is near or proximate to the charging device 200 (e.g., a near-charger event).

In some implementations, the condition generator 132a may be configured to determine whether an overall condition of a plurality of samples is satisfied (true) based on whether the magnitude condition is satisfied and/or whether the range condition is satisfied. For example, a sliding buffer (sliding window) with respect to a predetermined duration of time (e.g., the last second) of conditions may be maintained. If more than a threshold amount of the conditions in the sliding buffer indicates a particular condition (e.g., that a range value exceeds an axis threshold range value), an event (e.g., a near-charger event) may be output (e.g., via gating logic 132c), indicating that the user computing device 100 is near or proximate to the charging device 200. For example, the threshold amount of the conditions may correspond to a certain percentage amount (e.g., more than 80% of the conditions). For example, if more than 80% of 100 samples taken over the predetermined duration of time indicate the user computing device 100 is near or proximate to the charging device 200, the condition generator 132a or debouncer 132b may be configured to determine that the overall condition is satisfied (true). For example, if less than 80% of 100 samples taken over the predetermined duration of time indicate the user computing device 100 is near or proximate to the charging device 200 the condition generator 132a or debouncer 132b may be configured to determine that the overall condition is not satisfied (false). In some implementations, if the condition generator 132a or debouncer 132b determines the overall condition is satisfied, the charger detection sensor 132 (e.g., via gating logic 132c) may be configured to provide an output indicating the user computing device 100 is near or proximate to the charging device 200 (e.g., a near-charger event).

In some implementations, the condition generator 132a may be configured to analyze a plurality of samples over a predetermined duration of time and compute minimum range values and maximum range values per axis. The condition generator 132a may be configured to determine a condition is satisfied (true) if the difference between a minimum range value and a maximum range value for at least one axis exceeds a per axis threshold. In some implementations, if the condition generator 132a determines the overall condition is satisfied, the charger detection sensor 132 (e.g., via gating logic 132c) may be configured to provide an output indicating the user computing device 100 is near or proximate to the charging device 200 (e.g., a near-charger event).

Body detection sensor 133 may be configured to sense or output information (signals) indicating whether the user computing device 100 is placed (worn) on a body part of the user. For example, the body detection sensor 133 may be configured to detect whether the user computing device 100 is placed (worn) on the body part of the user based on one or more sensors. For example, an output of an optical sensor (e.g., a PPG sensor) may indicate the user computing device 100 is taken off or placed on the body part of the user based on the signal output by the optical sensor (e.g., the user computing device 100 may be determined to be removed due to a lack of or a significantly reduced blood flow detected by the optical sensor). For example, an output of an ambient light sensor may indicate the user computing device 100 is taken off or placed on the body part of the user based on the signal output by the ambient light sensor (e.g., the user computing device 100 may be determined to be removed due to an increase in an amount of sensed ambient light or if the amount of sensed ambient light exceeds a threshold ambient light level). For example, an output of a skin contact sensor may indicate the user computing device 100 is taken off or placed on the body part of the user based on the signal output by the skin contact sensor (e.g., the user computing device 100 may be determined to be removed due to a change in or magnitude of the measured electrical conductivity). For example, an output of a proximity sensor may indicate the user computing device 100 is taken off the body part of the user based on the signal output by the proximity sensor (e.g., the user computing device 100 may be determined to be removed due to a change in or magnitude of the measured distance). The body detection sensor 133 may be configured to use one or a combination of the above-described sensors to accurately detect whether the user computing device 100 is removed from the body part of the user or placed on the body part of the user.

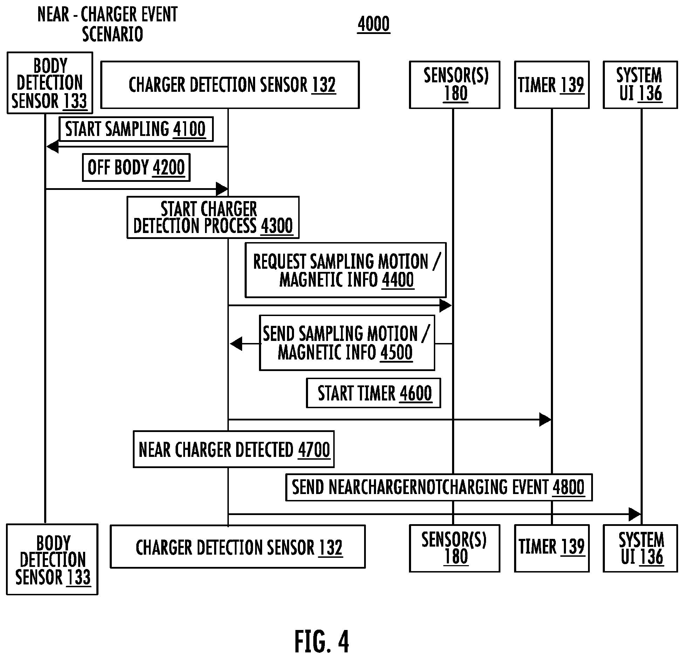

In some implementations, the charger detection sensor 132 may be configured to begin a process for determining whether the user computing device 100 is proximate to the charging device 200 in response to the body detection sensor 133 providing an output indicating the user computing device 100 is removed from the body part of the user. The charger detection sensor 132 may be configured to end the process for determining whether the user computing device 100 is proximate to the charging device 200 in response to the body detection sensor 133 providing an output indicating the user computing device 100 is placed on the body part of the user. Example charger detection processes are described with respect to FIGS. 4 through 7.

Debouncer 132b may be configured to monitor a signal output from the condition generator 132a to the debouncer 132b which indicates whether a condition is satisfied (e.g., a true condition) and which is indicative of the user computing device 100 being near or proximate to the charging device 200. For example, the debouncer 132b may be configured to ignore any changes to the output of the condition generator 132a that occur within a certain short time window (e.g., one second, two seconds, etc.) after receiving the initial signal output from the condition generator 132a to the debouncer 132b, to prevent false triggering of events caused by bouncing (e.g., due to inadvertent movement of the user computing device 100). As another example, if more than a threshold amount of the conditions in the sliding buffer indicates a particular condition (e.g., that a range value exceeds an axis threshold range value) that is contrary to the last output event (e.g., a near-charger event), then the debouncer may be configured to change the event condition (e.g., to an away-from-charger event) indicating that the user computing device 100 is not near or proximate to the charging device 200. For example, the threshold amount of the conditions may correspond to a certain percentage amount (e.g., more than 80% of the conditions). For example, if more than 80% of 100 samples taken over the predetermined duration of time indicate the user computing device 100 is not near or proximate to the charging device 200 while the last output event was a near-charger event, the debouncer 132b may be configured to determine that the overall condition is not satisfied (false). For example, if less than 20% of 100 samples taken over the predetermined duration of time indicate the user computing device 100 is near or proximate to the charging device 200 the debouncer 132b may be configured to determine that the overall condition is not satisfied (false). In some implementations, if the debouncer 132b determines the overall condition is satisfied (e.g.., more than 20% of 100 samples taken over the predetermined duration of time indicate the user computing device 100 is near or proximate to the charging device 200), the charger detection sensor 132 (e.g., via gating logic 132c) may be configured to maintain the output indicating the user computing device 100 is near or proximate to the charging device 200 (e.g., a near-charger event).

As described herein, first charging system 130 can an include an application processor 135 configured to execute an operating system, execute applications, and manage various tasks related to the user interface and functionality of the user computing device 100. As shown in FIG. 2, the application processor 135 can include a system user interface 136 that is configured to provide a user interface which can be presented to the user (e.g., via the display device 150 and/or the output device 160). The system user interface 136 includes an event listener 137 which is configured to listen for events output by charger detection sensor 132 (e.g., via gating logic 132c). In response to the detection of an event, the event listener 137 may be configured to provide output content 138. Output content 138 may include a visual display of content through the display device 150 and/or output device 160, audio content output by output device 160 (e.g., via a speaker), and/or haptic feedback output by output device 160 (e.g., via vibrations through a vibration or haptic device). In some implementations, the output content 138 may indicate (e.g., through text, imagery, sound, vibration pattern, etc.,) that the user computing device 100 is near a charging device 200 but is not being charged (e.g., in response to a near-charger event being detected by event listener 137). In some implementations, the output content 138 may indicate (e.g., through text, imagery, sound, vibration pattern, etc.,) that the user computing device 100 is coupled successfully to the charging device 200 and is being charged (e.g., in response to an active-charging event being detected by event listener 137).

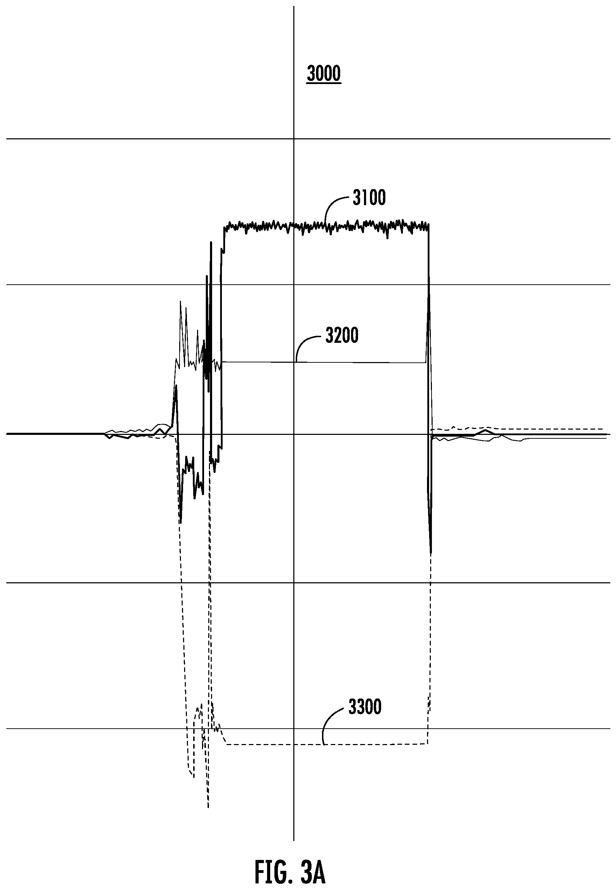

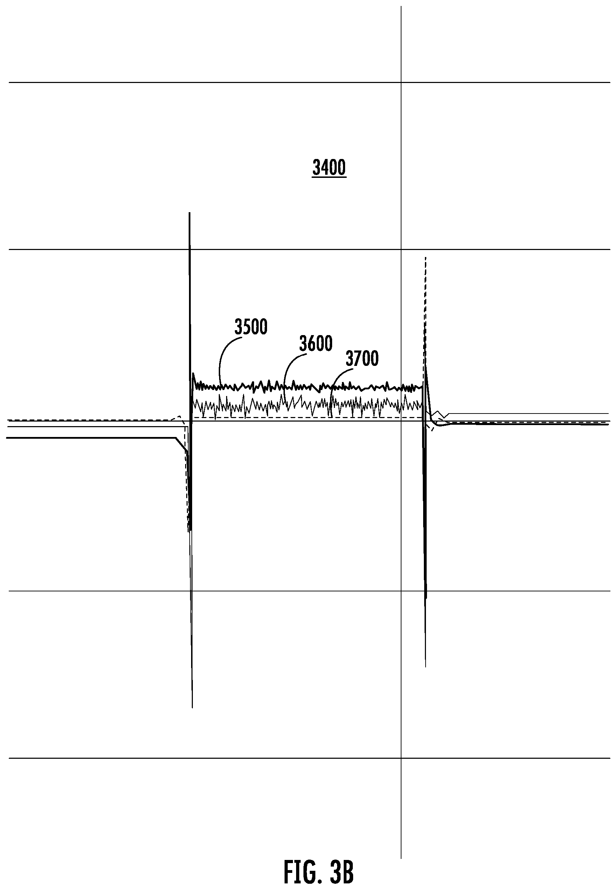

FIGS. 3A and 3B are example signals output by the magnetometer when provided near or proximate to a charging device, according to examples of the disclosure.

In some implementations, the magnetometer 183 may output signals having different characteristics depending upon an orientation of the magnetic field of the charging device 200 and the placement of the magnetometer 183 within the user computing device 100 which causes the output signal to have different magnitudes. In FIG. 3A, a first signal 3000 output by the magnetometer 183 has a relatively high magnitude (e.g., compared to the second signal 3400 of FIG. 3B), based on a first orientation of the magnetic field of the charging device 200 with respect to the magnetometer 183. In FIG. 3B, a second signal 3400 output by the magnetometer 183 has a relatively low magnitude (e.g., compared to the first signal 3000 of FIG. 3A), based on a second orientation of the magnetic field of the charging device 200 with respect to the magnetometer 183.

As shown in FIG. 3A, the output across one or more axes 3100, 3200, 3300 initially indicates a magnitude that is zero or near zero when the magnetometer 183 is not near a magnetic field. The magnitude of the signal then rises when the magnetometer 183 is disposed near a magnetic field, before returning to zero or near zero when the magnetometer 183 is again removed away from the magnetic field. As shown in FIG. 3A, the output across one or more axes 3100, 3200, 3300 can become noisy when the magnetometer 183 is disposed near or proximate to a strong magnetic field (e.g., near or proximate to the charging device 200 which include the one or more magnets 230). The charger detection sensor 132 (e.g., condition generator 132a) may be configured to classify a signal measured (output) by the magnetometer 183 as corresponding to a signal which represents a condition in which the magnetometer 183 is disposed near or proximate to a strong magnetic field (e.g., near or proximate to the charging device 200) or as a signal which does not represent a condition in which the magnetometer 183 is disposed near or proximate to a strong magnetic field (e.g., near or proximate to the charging device 200). In some implementations, the classification may be made at least partially based on the magnitude of the signal which can be associated with the orientation of the magnetic field. In some implementations, the charger detection sensor 132 (e.g., condition generator 132a) may be configured to use or implement a heuristic classifier, for example, which can implement rules or heuristics determined by domain experts or through empirical observation of the data. Therefore, in some implementations, through training and experimentation, the charger detection sensor 132 (e.g., condition generator 132a) may be able to distinguish between a magnetic field caused by a charging device and a magnetic field caused by some other object that has magnetic properties. However, the disclosure is not limited to heuristic classifiers and other techniques (e.g., machine-learning / artificial intelligence approaches) may be implemented to determine whether a signal output by the magnetometer 183 represents a condition in which the magnetometer 183 is disposed near or proximate to the charging device 200 or as a signal which does not represent a condition in which the magnetometer 183 is disposed near or proximate to the charging device 200 and/or to distinguish between a magnetic field caused by a charging device and a magnetic field caused by some other object that has magnetic properties.

Similar to FIG. 3A, as shown in FIG. 3B, the output across one or more axes 3500, 3600, 3700 initially indicates a magnitude that is zero or near zero when the magnetometer 183 is not near a magnetic field. The magnitude of the signal then rises when the magnetometer 183 is disposed near a magnetic field, before returning to zero or near zero when the magnetometer 183 is again removed away from the magnetic field. As shown in FIG. 3B, the output across one or more axes 3500, 3600, 3700 can become noisy (noisier than the output across the one or more axes 3100, 3200, 3300 of FIG. 3A) when the magnetometer 183 is disposed near or proximate to a strong magnetic field (e.g., near or proximate to the charging device 200). The charger detection sensor 132 (e.g., condition generator 132a) may be configured to classify a signal measured (output) by the magnetometer 183 as corresponding to a signal which represents a condition in which the magnetometer 183 is disposed near or proximate to a strong magnetic field (e.g., near or proximate to the charging device 200) or as a signal which does not represent a condition in which the magnetometer 183 is disposed near or proximate to a strong magnetic field (e.g., near or proximate to the charging device 200). In some implementations, the classification may be made at least partially based on the magnitude of the signal which can indicate the orientation of the magnetic field. In some implementations, the charger detection sensor 132 (e.g., condition generator 132a) may be configured to use or implement a heuristic classifier, for example, which can implement rules or heuristics determined by domain experts or through empirical observation of the data. Therefore, in some implementations, through training and experimentation, the charger detection sensor 132 (e.g., condition generator 132a) may be able to distinguish between a magnetic field caused by a charging device (e.g., caused by the one or more magnets 230 present in the charging device 200) and a magnetic field caused by some other object (e.g., a metal desk).

FIGS. 4 through 6 are example sequence diagrams of charger detection processes, according to examples of the disclosure. The sequence diagram 4000 of FIG. 4 illustrates an example in which the charger detection sensor 132 executes a process in which it is determined that the user computing device 100 is near or proximate to the charging device 200, but is not receiving a charge. Referring to the sequence diagram 4000 of FIG. 4, at operation 4100 the charger detection sensor 132 may be configured to start sampling the body detection sensor 133 to determine whether the user computing device 100 is worn by the user. - (e.g., regular intervals such as every one second), irregularly, at predetermined times (e.g., at a particular time(s) of day), in response to the occurrence of a particular event (e.g., an indication that a magnitude of a magnetic field sensed by the magnetometer 183 has increased by a threshold amount, an indication the user is about to engage in a particular in activity such as sleeping, waking, exercising, etc.), etc. In some implementations, the body detection sensor 133 may automatically provide an output to the charger detection sensor 132 indicating the user computing device 100 is not being worn on a body part of the user, and the charger detection sensor 132 need not sample the body detection sensor 133.

At operation 4200, the body detection sensor 133 provides an output that the user computing device 100 is not worn on a body part of the user.

In some implementations, operation 4100 may be omitted or modified. For example, operation 4100 may be omitted or modified for devices which are not normally worn directly on a body part of a user (e.g., a smartphone). For example, in some implementations the user computing device 100 can determine if it is being carried by a user or if it has been separated from or set aside by the user (e.g., via a combination of sensors including one or more of an ambient light sensor, inertial measurement unit, proximity sensor, etc. and/or machine-learned models which can determine based on sensor data whether the smartphone is being carried by a person or has been set aside). In response to the user computing device 100 determining the user computing device 100 is not being carried or has been set aside by the user, an output indicating the same may be provided to the charger detection sensor 132 (similar to operation 4200).

At operation 4300, in response to receiving the indication from the body detections sensor 133 that the user computing device 100 is not worn on the body part of the user, the charger detection sensor 132 is configured to start the charger detection process as described herein. Though not indicated in the sequence diagram, another condition that is satisfied in order for the charger detection sensor 132 to begin the charger detection process is that the user computing device 100 is not receiving a charge. The user computing device 100 (e.g., first charging system 130) may include charging circuitry which can detect a current and/or voltage which is supplied to the user computing device 100. The charging circuitry can provide an indication or output to the charger detection sensor 132 indicating whether a charge is being received.

Accordingly, in response to detecting (or receiving an output) the user computing device 100 is not receiving a charge and has been taken off a body part of the user, the charger detection sensor 132 may be configured to request that the one or more sensors 180 provide information to be used by the charger detection sensor 132 for determining whether the user computing device 100 is near or proximate to the charging device 200. For example, the charger detection sensor 132 may be configured to request that the inertial measurement unit 182 (e.g., the one or more accelerometers 182a and/or one or more gyroscopes 182b) provide motion information (e.g., acceleration information) indicating whether the user computing device 100 is in motion. For example, the charger detection sensor 132 may be configured to request that the magnetometer 183 provide information about a magnetic field sensed by the magnetometer (e.g., magnitude information, direction information regarding the magnetic field, etc.) which can indicate whether the user computing device 100 is near a magnetic field and in some implementations can indicate whether the user computing device 100 is near or proximate to the charging device 200. In some implementations, when the user computing device 100 is worn on the body part of the user, the sampling rate of the magnetometer 183 may be set to 0 Hz. In some implementations, the magnetometer 183 may be maintained at 0 Hz until the motion information indicates a movement of the user computing device 100 is less than a threshold movement level. In some implementations, the magnetometer 183 may be initially set to a low sampling rate of 5 Hz in response to the user computing device 100 being removed from the body part of the user and increased to 100 Hz in response to the motion information indicating the movement of the user computing device 100 being less than the threshold movement level.

At operation 4500, in response to receiving the request from the charger detection sensor 132 sent at operation 4400, the one or more sensors 180 may be configured to output the requested information to the charger detection sensor 132. In some implementations, in response to receiving the request from the charger detection sensor 132 sent at operation 4400, the magnetometer 183 may be configured to increase its sampling rate as described herein (e.g., from 0 Hz to 100 Hz, from 5 Hz to 100 Hz, etc.). In some implementations, the magnetometer 183 may be configured to delay or not begin measuring the magnetic field information until or unless the motion information measured by the inertial measurement unit 182 indicates the movement of the user computing device 100 is less than a threshold level or is stationary. In some implementations, the magnetometer 183 may be configured to maintain a current sampling rate or not increase its sampling rate until or unless the motion information measured by the inertial measurement unit 182 indicates the movement of the user computing device 100 is less than a threshold level or is stationary.

In conjunction with operations 4300 through 4500, the charger detection sensor 132 may be configured to start a timer via timer 139. Timer 139 may be part of controller 131, charger detection sensor 132, or some other component of user computing device 100. For example, the timer 139 may be set to a predetermined duration of time (e.g., one minute, two minutes, five minutes, etc.). The timer 139 may be implemented by the charger detection sensor 132 to limit a length of time at which the sampling rate of the magnetometer 183 is operated at the increased level, thereby conserving battery power of the user computing device 100. If the charger detection sensor 132 has not detected a condition that indicates the user computing device 100 is near or proximate to the charging device 200 (e.g., via the condition generator 132a, debouncer 132b, and gating logic 132c), the charger detection sensor 132 may be configured to end the process and the magnetometer 183 may be configured to decrease its sampling rate by returning to its default sampling rate (e.g., from 100 Hz to 5 Hz or 0 Hz). If the charger detection sensor 132 has detected a condition that indicates the user computing device 100 is near or proximate to the charging device 200 (e.g., via the condition generator 132a, debouncer 132b, and gating logic 132c), the charger detection sensor 132 may be configured to output information indicating the same (e.g., a NearChargerNotCharging event) to the system user interface 136. The information may be output to the event listener 137, for example.

As described herein, the system user interface 136 may be configured to alert or notify a user that the user computing device 100 is or appears to be near or proximate to a charging device 200, but is not receiving a charge. Therefore, the user can take corrective action to properly align or position the user computing device 100 with respect to the charging device 200 so that a charge is received by the user computing device 100, increasing uptime availability of the user computing device 100. The alert or notification can be output by the user computing device 100 and/or an external computing device (e.g., a smartphone associated with the user computing device 100, a server computing system or personal computer which can provide the notification to the user via a messaging application such as e-mail, an app, etc.).

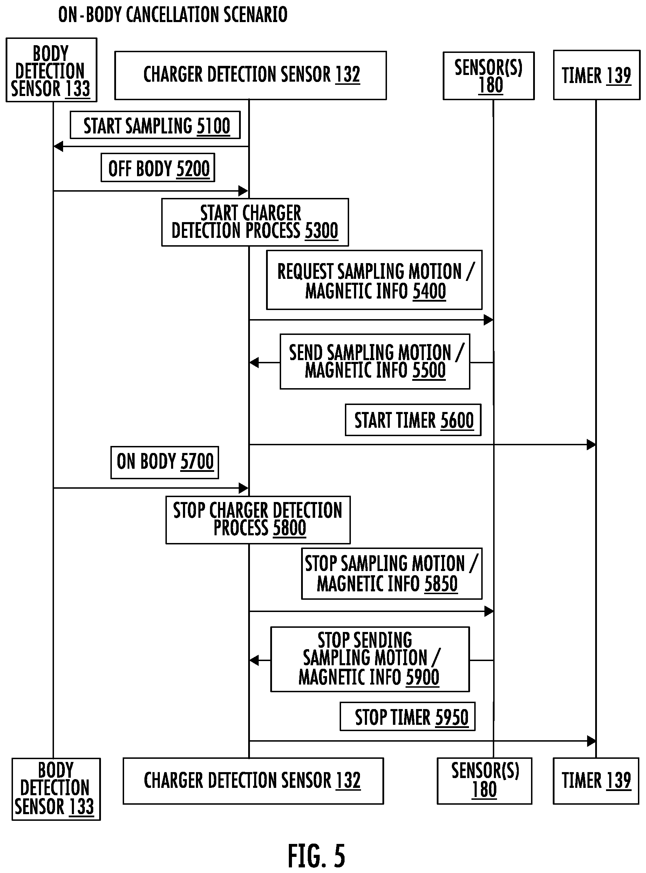

The sequence diagram 5000 of FIG. 5 illustrates an example in which the charger detection sensor 132 executes a process to determine whether the user computing device 100 is near or proximate to the charging device 200, but does not receive such an indication and the process is ended in response to a determination that the user computing device 100 is placed on a body part of the user. Referring to the sequence diagram 5000 of FIG. 5, operations 5100 through 5600 are the same as operations 4100 through 4600, and therefore a description of those operations will not be repeated again for the sake of brevity.

At operation 5700 of FIG. 5, during the predetermined duration of time that the timer 139 has been set (e.g., the predetermined duration of time has not elapsed), the body detection sensor 133 provides an output to the charger detection sensor 132 that the user computing device 100 is now worn on the body part of the user. In response to receiving this output from the body detection sensor 133, at operation 5800, the charger detection sensor 132 is configured to end the charger detection process. In some implementations, at operation 5850 the charger detection sensor 132 provides an output to the one or more sensors 180 to stop providing information to be used by the charger detection sensor 132 for determining whether the user computing device 100 is near or proximate to the charging device 200. For example, the charger detection sensor 132 may be configured to request that the inertial measurement unit 182 (e.g., the one or more accelerometers 182a and/or one or more gyroscopes 182b) stop providing motion information (e.g., acceleration information) indicating whether the user computing device 100 is in motion. For example, the charger detection sensor 132 may be configured to request that the magnetometer 183 stop providing information about a magnetic field sensed by the magnetometer (e.g., magnitude information, direction information regarding the magnetic field, etc.) which can indicate whether the user computing device 100 is near a magnetic field and in some implementations can indicate whether the user computing device 100 is near or proximate to the charging device 200.

In response to receiving the output of operation 5850 from the charger detection sensor 132, at operation 5900 the one or more sensors 180 are configured to stop sending information to be used by the charger detection sensor 132 for determining whether the user computing device 100 is near or proximate to the charging device 200. For example, the inertial measurement unit 182 (e.g., the one or more accelerometers 182a and/or one or more gyroscopes 182b) may stop providing motion information (e.g., acceleration information) indicating whether the user computing device 100 is in motion. For example, the magnetometer 183 may stop providing information about a magnetic field sensed by the magnetometer 183 (e.g., magnitude information, direction information regarding the magnetic field, etc.) which can indicate whether the user computing device 100 is near a magnetic field and in some implementations can indicate whether the user computing device 100 is near or proximate to the charging device 200. In some implementations, at operation 5900 the one or more sensors 180 may be configured to stop measuring or sampling motion information and magnetic information in response to receiving the request from the charger detection sensor 132 at operation 5850. In some implementations, at operation 5900 the magnetometer 183 may be configured to decrease its sampling rate by returning to its default sampling rate (e.g., from 100 Hz to 5 Hz).

At operation 5950 the charger detection sensor may be configured to stop the timer 139. Though not shown in FIG. 5, in some implementations, the charger detection sensor 132 may be configured to output information indicating the charger detection process has ended (e.g., a ChargerDetectionProcessEnded event) to the system user interface 136. The information may be output to the event listener 137, for example.

As described herein, the system user interface 136 may be configured to alert or notify a user that the charger detection process has ended, for example, due to the user computing device 100 being placed on a body part of the user during the predetermined duration of time. Therefore, the user can take corrective action if the placement of the user computing device 100 on the body part of the user was inadvertent or if the user assumed that the user computing device 100 was being charged during the predetermined duration of time, which can increase uptime availability of the user computing device 100. The alert or notification can be output by the user computing device 100 and/or an external computing device (e.g., a smartphone associated with the user computing device 100, a server computing system or personal computer which can provide the notification to the user via a messaging application such as e-mail, an app, etc.). In some implementations, no notification or alert is provided via the system user interface 136 due to the user computing device 100 being placed on a body part of the user during the predetermined duration of time.

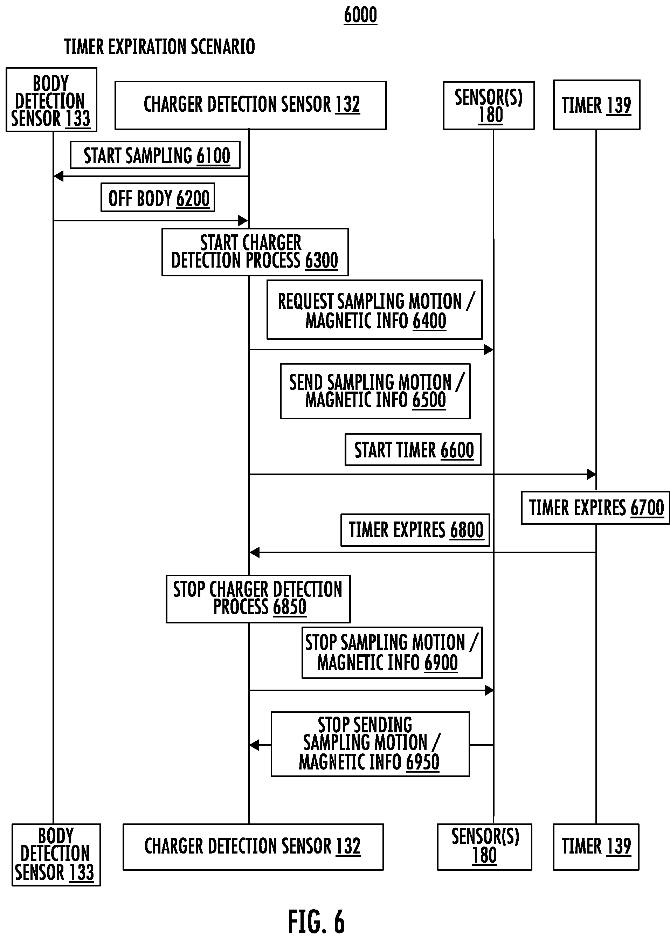

The sequence diagram 6000 of FIG. 6 illustrates an example in which the charger detection sensor 132 executes a process to determine whether the user computing device 100 is near or proximate to the charging device 200, but does not receive such an indication and the process is ended in response to a determination that the predetermined duration of time set for the timer 139 has expired or elapsed. Referring to the sequence diagram 6000 of FIG. 6, operations 6100 through 6600 are the same as operations 4100 through 4600, and therefore a description of those operations will not be repeated again for the sake of brevity.

At operation 6700 of FIG. 6, the predetermined duration of time that the timer 139 has been set to has elapsed or expired. In response, to the timer 139 determining that the predetermined duration of time has elapsed or expired, at operation 6800 the timer 139 may be configured to provide an output to the charger detection sensor 132 that the predetermined duration of time that the timer 139 has been set to has elapsed or expired.

At operation 6850, in response to receiving the output from the timer 139 at operation 6800, the charger detection sensor 132 is configured to end the charger detection process. In some implementations, at operation 6900 the charger detection sensor 132 provides an output to the one or more sensors 180 to stop providing information to be used by the charger detection sensor 132 for determining whether the user computing device 100 is near or proximate to the charging device 200. For example, the charger detection sensor 132 may be configured to request that the inertial measurement unit 182 (e.g., the one or more accelerometers 182a and/or one or more gyroscopes 182b) stop providing motion information (e.g., acceleration information) indicating whether the user computing device 100 is in motion. For example, the charger detection sensor 132 may be configured to request that the magnetometer 183 stop providing information about a magnetic field sensed by the magnetometer 183 (e.g., magnitude information, direction information regarding the magnetic field, etc.) which can indicate whether the user computing device 100 is near a magnetic field and in some implementations can indicate whether the user computing device 100 is near or proximate to the charging device 200.

In response to receiving the output of operation 6900 from the charger detection sensor 132, at operation 6950 the one or more sensors 180 are configured to stop sending information to be used by the charger detection sensor 132 for determining whether the user computing device 100 is near or proximate to the charging device 200. For example, the inertial measurement unit 182 (e.g., the one or more accelerometers 182a and/or one or more gyroscopes 182b) may stop providing motion information (e.g., acceleration information) indicating whether the user computing device 100 is in motion. For example, the magnetometer 183 may stop providing information about a magnetic field sensed by the magnetometer 183 (e.g., magnitude information, direction information regarding the magnetic field, etc.) which can indicate whether the user computing device 100 is near a magnetic field and in some implementations can indicate whether the user computing device 100 is near or proximate to the charging device 200. In some implementations, at operation 6950 the one or more sensors 180 may be configured to stop measuring or sampling motion information and magnetic information in response to receiving the request from the charger detection sensor 132 at operation 6900. In some implementations, at operation 6950 the magnetometer 183 may be configured to decrease its sampling rate by returning to its default sampling rate (e.g., from 100 Hz to 5 Hz or 0 Hz).

Though not shown in FIG. 6, in some implementations, the charger detection sensor 132 may be configured to output information indicating the charger detection process has ended (e.g., a ChargerDetectionProcessEnded event) to the system user interface 136. The information may be output to the event listener 137, for example.

As described herein, the system user interface 136 may be configured to alert or notify a user that the charger detection process has ended, for example, due to the predetermined duration of time that the timer 139 has been set to having elapsed or expired. Therefore, the user can take corrective action if the user assumed that the user computing device 100 was being charged (e.g., during the predetermined duration of time,) which can increase uptime availability of the user computing device 100. The alert or notification can be output by the user computing device 100 and/or an external computing device (e.g., a smartphone associated with the user computing device 100, a server computing system or personal computer which can provide the notification to the user via a messaging application such as e-mail, an app, etc.). In some implementations, no notification or alert is provided via the system user interface 136 due to the predetermined duration of time that the timer 139 has been set to having elapsed or expired.

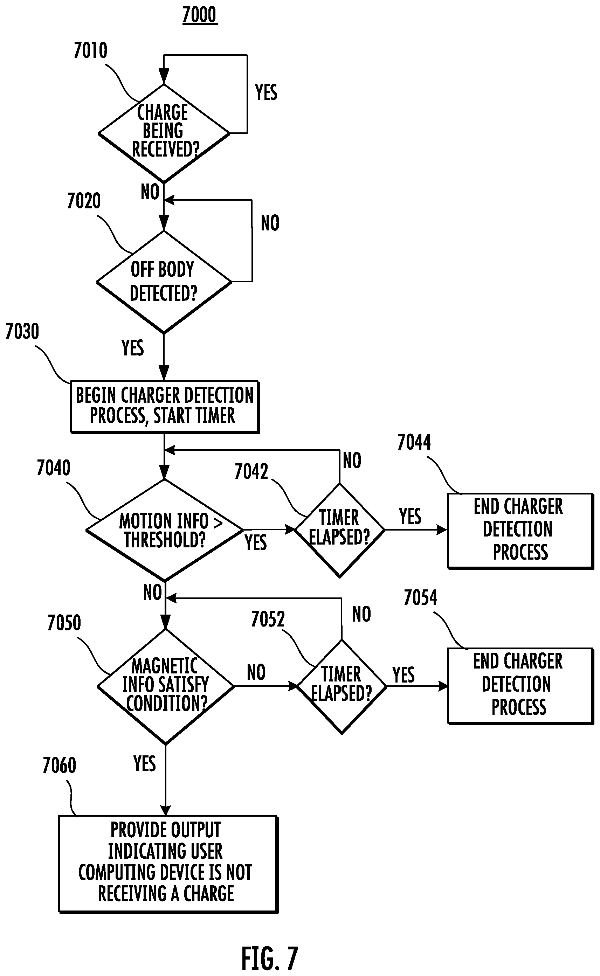

FIG. 7 is a flow diagram of an example, non-limiting computer-implemented method according to one or more examples of the disclosure.

The flow diagram of FIG. 7 illustrates a method 7000 for a user computing device (e.g., a wearable computing device) to determine whether the user computing device is near or proximate to a charging device, according to examples of the disclosure. Although shown in a particular sequence or order, unless otherwise specified, the order of the processes can be modified. Thus, the illustrated embodiments should be understood only as examples, and the illustrated processes can be performed in a different order, and some processes can be performed in parallel. Additionally, one or more processes can be omitted in various embodiments. Thus, not all processes are required in every embodiment. Other process flows are possible.

According to the method 7000, the user computing device 100 detects whether the user computing device 100 is receiving a charge from the charging device 200, and when the user computing device 100 is not receiving the charge, the user computing device 100 determines, based on one or more first signals (e.g., magnetic signals) output by one or more first sensors (e.g., one or more magnetometers), whether the user computing device 100 is proximate to the charging device 200. When the user computing device 100 is determined, based on the one or more first signals output by the one or more first sensors, to be proximate to the charging device 200, the user computing device 100 provides an output indicating the user computing device 100 is not receiving the charge.

In more detail, at operation 7010, the method 7000 includes the user computing device 100 determining whether a charge is being received. For example, the user computing device 100 can include charging circuitry which is configured to detect a current and/or voltage which is supplied to the user computing device 100. In some implementations, the charging circuitry can provide an indication or output to the charger detection sensor 132 indicating whether a charge is being received. If a charge is being received (Yes), the method 7000 may return to operation 7010. If a charge is not being received (No), the method 7000 may continue to operation 7020.

At operation 7020, the method 7000 includes determining whether the user computing device 100 is being worn or provided on the body of a user associated with the user computing device 100. In some implementations, the body detection sensor 133 may be configured to sense or output information (signals) indicating whether the user computing device 100 is placed (worn) on a body part of the user. The body detection sensor 133 may include one or more of an optical sensor, ambient light sensor, proximity sensor, skin contact sensor, etc., to provide an indication as to whether the user computing device 100 is provided on a body part of the user or has been removed from the body part of the user. If the user computing device 100 is provided on the body part of the user (No), the method 7000 may return to operation 7020 (or back to operation 7010 in some implementations). If the user computing device 100 is not provided on the body part of the user (Yes), the method 7000 may continue to operation 7030.

In some implementations, operation 7020 may be omitted or modified. For example, operation 7020 may be omitted or modified for devices which are not normally worn directly on a body part of a user (e.g., a smartphone). For example, in some implementations the user computing device 100 can determine if it is being carried by a user or if it has been separated from or set aside by the user (e.g., via a combination of sensors including one or more of an ambient light sensor, inertial measurement unit, proximity sensor, etc. and/or machine-learned models which can determine based on sensor data whether the smartphone is being carried by a person or has been set aside). In response to the user computing device 100 determining the user computing device 100 is not being carried or has been set aside by the user, an output indicating the same may be provided to the charger detection sensor 132.

At operation 7030 the method 7000 includes beginning the charger detection process and starting a timer. For example, the charger detection process may be implemented via the charger detection sensor 132. As described herein, in some implementations the charger detection sensor 132 can determine (in response to the detection that the user computing device 100 is not being charged and has been removed from a body part of the user), whether the user computing device 100 is near or proximate to the charging device 200 (e.g., in some implementations, if the user computing device 100 is stationary and a magnetic field sensed by the magnetometer 183 exhibits certain characteristics that correspond to expected characteristics of a user computing device 100 that is near or proximate to a charging device). In association with beginning the charger detection process, in some implementations the timer 139 may be set to a predetermined duration of time (e.g., 1 minute, 2 minutes, 5 minutes, etc.).

In association with beginning the charger detection process, in some implementations the sample rate of the magnetometer 183 may be increased from a first sampling rate to a second sampling rate. For example, when the user computing device 100 is not receiving the charge and a signal output by the body detection sensor 133 indicates the user computing device 100 is not worn on the body part of the user, the user computing device 100 (e.g., charger detection sensor 132) may be configured to change the sampling rate of the magnetometer 183 from a first sampling rate to a second sampling rate, the second sampling rate being greater than the first sampling rate (e.g., from 5 Hz to 100 Hz). Although an example of 5 Hz and 100 Hz have been provided for the first and second sampling rates, respectively, other values may be used (e.g., 0 Hz and 100 Hz, 5 Hz and 60 Hz, 0 Hz and 60 Hz, 20 Hz and 40 Hz, 0 Hz and 40 Hz, etc.). A higher sampling rate results in obtaining more information (data) within a given time such that noise in the signal can be detected more accurately and more variance data can be observed. However, the higher sampling rate can result in increased power usage. In some implementations, the second (higher) sampling rate may be maintained for a threshold duration of time. For example, the threshold duration of time may correspond to the predetermined duration of time set by the timer 139. Therefore, limiting the charger detection process to a predetermined duration of time can conserve battery power usage. In some implementations, after the threshold duration of time elapses (expires), the user computing device 100 (e.g., the charger detection sensor 132) may be configured to change the sampling rate from the second sampling rate to the first sampling rate (e.g., to conserve battery power).

At operation 7040, the method 7000 includes determining whether movement of the user computing device 100 exceeds a threshold movement level. For example, the user computing device 100 can include one or more motion sensors (second sensors) which are configured to output one or more second signals indicating a movement associated with the user computing device 100 measured via the one or more movement sensors. The one or more movement sensors can include the inertial measurement unit 182 having the one or more accelerometers 182a and/or one or more gyroscopes 182b. The one or more accelerometers 182a may be used to capture motion information with respect to the user computing device 100. The one or more gyroscopes 182b may also be used additionally or alternatively to capture motion information with respect to the user computing device 100.

When the one or more motion signals indicate the movement associated with the user computing device 100 is less than the threshold movement level, the user computing device 100 (e.g., charger detection sensor 132, condition generator 132a) may be configured to determine, based on the one or more motion signals output by the one or more motion sensors, whether the user computing device 100 is proximate to the charging device 200 - that is the method 7000 may continue to operation 7050 based on the indication that the user computing device 100 is stationary or has a movement level below the threshold movement level.

In some implementations, when the one or more motion signals indicate the movement associated with the user computing device 100 is more than the threshold movement level, the user computing device 100 (e.g., charger detection sensor 132, condition generator 132a) may be configured to continue monitoring the movement level of the user computing device 100 by returning to operation 7040 if the user computing device 100 (e.g., charger detection sensor 132, condition generator 132a) determines at operation 7042 the predetermined duration of time set by the timer 139 has not elapsed. In some implementations, operations 7040 and 7050 can be performed at the same time. For example, while the one or more motion signals output at operation 7040 indicate the movement associated with the user computing device 100 is more than the threshold movement level, outputs generated via the magnetometer 183 at operation 7050 are ignored by the condition generator 132a and no determination is made as to whether the user computing device 100 is near or proximate to the charging device 200. If the predetermined duration of time set by the timer 139 has elapsed, the user computing device 100 (e.g., charger detection sensor 132, condition generator 132a) may be configured to proceed to operation 7044 and end the method 7000. In some implementations, the method 7000 may be ended immediately when the one or more motion signals indicate the movement associated with the user computing device 100 is more than the threshold movement level at operation 7040. Ending the charging detection process at operation 7044 may include reducing the sampling rate of the magnetometer 183 (e.g., from the second (higher) sampling rate to the first (lower or default) sampling rate).

While FIG. 7 illustrates that the timer is started at operation 7030, in some implementations, the timer may not begin until after it is determined that the movement of the user computing device 100 is less than the threshold movement level at operation 7040. In such a case, operation 7040 may be repeated or the method may return to operation 7010 if it is determined that the movement of the user computing device 100 is greater than the threshold movement level. For example, the sampling rate of the magnetometer 183 may not be increased unless and until the movement of the user computing device 100 is below the threshold movement level, the user computing device 100 is not worn on the body part of the user, and/ the user computing device 100 is not receiving a charge. For example, the timer 139 may not be set to the predetermined duration of time and started unless and until the movement of the user computing device 100 is below the threshold movement level, the user computing device 100 is not worn on a body part of the user, and the user computing device 100 is not receiving a charge.

At operation 7050, the method 7000 includes the user computing device 100 (e.g., charger detection sensor 132, condition generator 132a) determining whether the magnetic information output by the magnetometer 183 satisfies certain conditions. As described herein, the conditions can relate to or be associated with a magnitude of the magnetic signal and/or a range of the magnetic signal. Thus, the user computing device 100 is configured to determine, based on one or more magnetic signals (first signals) output by the magnetometer 183 (one or more first sensors), whether the user computing device 100 is proximate to the charging device 200.

As an example, the condition generator 132a may be configured to implement a first condition to determine whether the user computing device 100 is proximate to the charging device 200. For example, the first condition may be satisfied if the condition generator 132a determines the magnitude of the magnetic signal output by the magnetometer 183 exceeds a threshold magnitude value. Thus, the condition generator 132a may be configured to determine at least one magnitude value based on the one or more magnetic signals, determine whether the at least one magnitude value satisfies the threshold magnitude value, and when the at least one magnitude value satisfies the threshold magnitude value, determine the user computing device 100 is proximate to the charging device 200. For example, the at least one magnitude value may correspond to a maximum magnitude value among a plurality of magnitude values sampled during a predetermined duration of time. For example, if 100 samples are obtained in one second with a sampling rate of 100 Hz, the highest magnitude value obtained during the one second may be compared to the threshold magnitude value. In some implementations, an average magnitude value during the predetermined duration of time may be compared to the threshold magnitude value. As described herein, the magnetometer 183 can measure magnetic information along a plurality of axes. In some implementations, the condition generator 132a can be configured to determine magnitude values for each axis and can determine the first condition to be satisfied when at least one of the magnitude values determined for each of the plurality of axes satisfies (e.g., is greater than) the threshold magnitude value. In some implementations, the threshold magnitude value may be determined (change) based on an orientation of the user computing device 100 with respect to the charging device 200 (for example, as discussed with respect to FIGS. 3A and 3B).

As an example, the condition generator 132a may be configured to implement a second condition to determine whether the user computing device 100 is proximate to the charging device 200. For example, the second condition may be satisfied if the condition generator 132a determines the range of the magnetic signal output by the magnetometer 183 exceeds a threshold magnitude range value. Thus, the condition generator 132a may be configured to determine at least one magnitude range value based on the one or more magnetic signals, determine whether the at least one magnitude range value satisfies a threshold magnitude range value, and when the at least one magnitude range value satisfies the threshold magnitude range value, determine the user computing device 100 is proximate to the charging device 200. The at least one magnitude range value corresponds to a difference between a maximum magnitude value among a plurality of magnitude values sampled during a predetermined duration of time and a minimum magnitude value among the plurality of magnitude values sampled during the predetermined duration of time. As described herein, the magnetometer 183 can measure magnetic information along a plurality of axes. In some implementations, the condition generator 132a can be configured to determine the magnitude range values for each axis and can determine the second condition to be satisfied when at least one of the magnitude range values determined for each of the plurality of axes satisfies (e.g., is greater than) the threshold magnitude range value. In some implementations, the threshold magnitude range value may be determined (changed) based on an orientation of the user computing device 100 with respect to the charging device 200 (for example, as discussed with respect to FIGS. 3A and 3B).

As an example, the condition generator 132a may be configured to implement a third condition to determine whether the user computing device 100 is proximate to the charging device 200. For example, the third condition may be satisfied if the condition generator 132a determines the first condition and the second condition are satisfied.

In some implementations, the condition generator 132a may be configured to implement an "overall" (fourth) condition to determine whether the user computing device 100 is proximate to the charging device 200 For example, if the condition generator 132a implements the first condition, the condition generator 132a may be configured to determine the overall condition is satisfied if the first condition is satisfied a predetermined number of times or predetermined amount within a predetermined duration of time (a sliding buffer or sliding window). For example, the condition generator 132a can be configured to determine magnitude values based on the one or more magnetic signals over a predetermined duration of time (e.g., ten seconds), determine, for each of a plurality of intervals of time (e.g., every one second) over the predetermined duration of time, whether at least one magnitude value from each interval among the plurality of intervals satisfies a threshold magnitude value, and when the threshold magnitude value is satisfied for a threshold number of intervals among the plurality of intervals, determine the overall condition is satisfied (e.g., determine the user computing device 100 is proximate to the charging device 200). For example, if the sliding buffer is ten seconds and the first condition is evaluated ten times during the ten seconds, the condition generator 132a may determine the overall condition to be satisfied if the first condition is satisfied at least eight times or at least eighty percent of the time. The overall condition may also be implemented by the condition generator 132a in a similar manner to the second and third conditions.

If the condition generator 132a determines the magnetic information satisfies an implemented condition (e.g., the first condition, second condition, third condition, overall condition, etc.), the method may proceed to operation 7060. If the condition generator 132a determines the magnetic information does not satisfy the implemented condition (e.g., the first condition, second condition, third condition, overall condition, etc.), the method may proceed to operation 7052.

In some implementations, when the magnetic information does not satisfy the implemented condition, the user computing device 100 (e.g., charger detection sensor 132, condition generator 132a) may be configured to continue monitoring the magnetic information with respect to the implemented condition by returning to operation 7050 if the user computing device 100 (e.g., charger detection sensor 132, condition generator 132a) determines at operation 7052 the predetermined duration of time set by the timer 139 has not elapsed. If the predetermined duration of time set by the timer 139 has elapsed, the user computing device 100 (e.g., charger detection sensor 132, condition generator 132a) may be configured to proceed to operation 7054 and end the method 7000. In some implementations, the method 7000 may be ended immediately when the magnetic information does not satisfy the implemented condition at operation 7050. Ending the charging detection process at operation 7054 may include reducing the sampling rate of the magnetometer 183 (e.g., from the second (higher) sampling rate to the first (lower or default) sampling rate).

At operation 7060, in response to determining the magnetic information does satisfy the implemented condition at operation 7050 (as well as the prior determinations that the movement of the user computing device 100 is less than the threshold movement level, is not worn on a body part of the user, and is not receiving a charge), the user computing device 100 may be configured to provide an output indicating the user computing device 100 is not receiving a charge and is proximate to or near a charging device.

For example, if the charger detection sensor 132 detects or determines that the user computing device 100 is near or proximate to the charging device 200 (e.g., via the condition generator 132a, debouncer 132b, and gating logic 132c), the charger detection sensor 132 may be configured to output information indicating the same (e.g., a NearChargerNotCharging event) to the system user interface 136.

For example, the system user interface 136 may be configured to alert or notify a user that the user computing device 100 is or appears to be near or proximate to a charging device 200, but is not receiving a charge (e.g., via at least one of haptic feedback, audio feedback, or a visual representation on the display device 150 of the user computing device 100). Therefore, the user can take corrective action to properly align or position the user computing device 100 with respect to the charging device 200 so that a charge is received by the user computing device 100, increasing uptime availability of the user computing device 100. The alert or notification can be output by the user computing device 100 and/or an external computing device (e.g., a smartphone associated with the user computing device 100, a server computing system or personal computer which can provide the notification to the user via a messaging application such as e-mail, an app, etc.). For example, a message can be displayed on a user interface screen (e.g., via display device 150) indicating to the user that the user computing device 100 is proximate to a charging device 200 but is not receiving a charge. The message can be a visual graphic, an animation, etc. For example, a message can be output (played) via a speaker (e.g., via the output device 160) indicating to the user that the user computing device 100 is proximate to a charging device 200 but is not receiving a charge. For example, a vibration can be output via a haptic device (e.g., via the output device 160) indicating to the user that the user computing device 100 is proximate to a charging device 200 but is not receiving a charge. For example, the vibration can follow a particular pattern that is associated with the indication. For example, the indication can be output to an external computing device (e.g., a smartphone) and the external computing device can be configured to notify or alert the user via one or more of the visual, audio, or vibration methods described herein.

For example, in association with ending the charger detection process (e.g., at operation 7044 and/or operation 7054) the system user interface 136 may also be configured to alert or notify a user that the charger detection process has ended, for example, due to the user computing device 100 being placed on a body part of the user during the predetermined duration of time, due to the timer expiring, due to movement of the user computing device 100 exceeding a threshold movement level, etc.). Therefore, the user can take corrective action if the placement of the user computing device 100 on the body part of the user was inadvertent or if the user assumed that the user computing device 100 was being charged during the predetermined duration of time, which can increase uptime availability of the user computing device 100. The alert or notification can be output by the user computing device 100 and/or an external computing device as described herein. In some implementations, no notification or alert is provided via the system user interface 136 when the charger detection process ends.

In some implementations, the output provided at operation 7060 indicating the user computing device 100 is not receiving the charge (and is proximate to or near the charging device 200) is maintained for a threshold duration of time irrespective of whether the user computing device 100 makes a different determination regarding whether the user computing device 100 is proximate to the charging device 200 within the threshold duration of time.

For example, debouncer 132b may be configured to monitor a signal output from the condition generator 132a to the debouncer 132b which indicates whether the implemented condition is satisfied (e.g., a true condition) and which is indicative of the user computing device 100 being near or proximate to the charging device 200. For example, the debouncer 132b may be configured to ignore any changes to the output of the condition generator 132a that occur within a certain short time window (e.g., one second, two seconds, etc.) after receiving the initial signal output from the condition generator 132a to the debouncer 132b, to prevent false triggering of events caused by bouncing (e.g., due to inadvertent movement of the user computing device 100). In some implementations, the charger detection sensor 132 (e.g., the debouncer 132b) may also be configured to limit a number of times the output indicating the user computing device 100 is not receiving the charge is provided, to a threshold number of times within a threshold duration of time. For example, the charger detection sensor 132 may be configured to provide the output at operation 7060 over a threshold duration of time a limited number of times so that the user is not inconvenienced with numerous messages, and computing resources can also be conserved.

In some implementations, after the output is provided at operation 7060, the sampling rate of the magnetometer 183 may be changed back from the second (higher) sampling rate to the first (lower) sampling rate.

In some implementations, after the output is provided at operation 7060, after a threshold duration of time has elapsed after providing the output indicating the user computing device 100 is not receiving the charge, the sampling rate of the magnetometer 183 may be configured to change (e.g., from a first sampling rate to a second sampling rate, the second sampling rate being less than the first sampling rate).

In some implementations, after the output is provided at operation 7060 and in response to the user computing device 100 (e.g., first charging system 130) detecting the user computing device 100 (e.g., first charging system 130) is receiving the charge, the sampling rate of the magnetometer 183 may be configured to change the sampling rate (e.g., from a first sampling rate to a second sampling rate, the second sampling rate being less than the first sampling rate).

In some implementations, after the output is provided at operation 7060 and in response to an indication from the body detection sensor 133 that the user computing device 100 is worn on a body part of the user, the sampling rate of the magnetometer 183 may be changed (e.g., from a first (higher) sampling rate to a second (lower) sampling rate).

Aspects of the above-described example embodiments may be recorded in non-transitory computer-readable media including program instructions to implement various operations embodied by a computer. The media may also include, alone or in combination with the program instructions, data files, data structures, and the like. Examples of non-transitory computer-readable media include magnetic media such as hard disks, floppy disks, and magnetic tape; optical media such as CD ROM disks, Blu-Ray disks, and DVDs; magneto-optical media such as optical discs; and other hardware devices that are specially configured to store and perform program instructions, such as semiconductor memory, read-only memory (ROM), random access memory (RAM), flash memory, USB memory, and the like. Examples of program instructions include both machine code, such as produced by a compiler, and files containing higher level code that may be executed by the computer using an interpreter. The program instructions may be executed by one or more processors. The described hardware devices may be configured to act as one or more software modules in order to perform the operations of the above-described embodiments, or vice versa. In addition, a non-transitory computer-readable storage medium may be distributed among computer systems connected through a network and computer-readable codes or program instructions may be stored and executed in a decentralized manner. In addition, the non-transitory computer-readable storage media may also be embodied in at least one application specific integrated circuit (ASIC) or Field Programmable Gate Array (FPGA).

Each block of the flowchart illustrations may represent a unit, module, segment, or portion of code, which comprises one or more executable instructions for implementing the specified logical function(s). It should also be noted that in some alternative implementations, the functions noted in the blocks may occur out of order. For example, two blocks shown in succession may in fact be executed substantially concurrently (simultaneously) or the blocks may sometimes be executed in the reverse order, depending upon the functionality involved.

While the disclosure has been described with respect to various example embodiments, each example is provided by way of explanation, not limitation of the disclosure. Those skilled in the art, upon attaining an understanding of the foregoing, can readily produce alterations to, variations of, and equivalents to such embodiments. Accordingly, the disclosure does not preclude inclusion of such modifications, variations and/or additions to the disclosed subject matter as would be readily apparent to one of ordinary skill in the art. For example, features illustrated or described as part of one embodiment can be used with another embodiment to yield a still further embodiment. Thus, it is intended that the disclosure covers such alterations, variations, and equivalents.

## Claims

1. A user computing device, comprising:
one or more first sensors configured to output one or more first signals based on a magnetic field measured via the one or more first sensors;
one or more memories configured to store instructions; and
one or more processors configured to execute the instructions to perform operations, the operations comprising:
detecting whether the user computing device is receiving a charge from a charging device,
when the user computing device is not receiving the charge, determining, based on the one or more first signals output by the one or more first sensors, whether the user computing device is proximate to the charging device, and
when the user computing device is determined, based on the one or more first signals output by the one or more first sensors, to be proximate to the charging device, providing an output indicating the user computing device is not receiving the charge.

2. The user computing device of claim 1, further comprising:
one or more second sensors configured to output one or more second signals indicating a movement associated with the user computing device measured via the one or more second sensors, and
the operations further comprise when the user computing device is not receiving the charge and the one or more second signals indicate the movement associated with the user computing device is less than a threshold movement level, determining, based on the one or more second signals output by the one or more second sensors, whether the user computing device is proximate to the charging device.

3. The user computing device of claim 2, further comprising:
one or more third sensors configured to output one or more third signals indicating whether the user computing device is worn on a body part of a user, and
the operations further comprise, when the user computing device is not receiving the charge and the one or more third signals indicate the user computing device is not worn on the body part of the user, changing a sampling rate of the one or more first sensors from a first sampling rate to a second sampling rate, wherein the second sampling rate is greater than the first sampling rate.

4. The user computing device of claim 3, wherein the operations comprise:
maintaining the second sampling rate for a threshold duration of time,
and, optionally, after the threshold duration of time elapses, changing the sampling rate from the second sampling rate to the first sampling rate.

5. The user computing device of claim 1, wherein the operations further comprise:
in response to providing the output indicating the user computing device is not receiving the charge, changing a sampling rate of the one or more first sensors from a first sampling rate to a second sampling rate, the second sampling rate being less than the first sampling rate; and/or
after a threshold duration of time has elapsed after providing the output indicating the user computing device is not receiving the charge, changing a sampling rate of the one or more first sensors from a first sampling rate to a second sampling rate, the second sampling rate being less than the first sampling rate; and/or
after providing the output indicating the user computing device is not receiving the charge and in response to the one or more processors detecting the user computing device is receiving the charge, changing a sampling rate of the one or more first sensors from a first sampling rate to a second sampling rate, the second sampling rate being less than the first sampling rate.

6. The user computing device of any one of the preceding claims, further comprising:
one or more second sensors configured to output one or more second signals indicating whether the user computing device is worn on a body part of a user, and
the operations further comprise:
after providing the output indicating the user computing device is not receiving the charge and in response to the one or more second signals indicating the user computing device is worn on the body part of the user, changing a sampling rate of the one or more first sensors from a first sampling rate to a second sampling rate, the second sampling rate being less than the first sampling rate.

7. The user computing device of any one of the preceding claims, wherein the output includes at least one of haptic feedback, audio feedback, or a visual representation on a display device of the user computing device, indicating the user computing device is not receiving the charge, and, optionally, the output includes transmitting a communication to an external computing device indicating the user computing device is not receiving the charge.

8. The user computing device of any one of the preceding claims, wherein the operations further comprise limiting a number of times the output indicating the user computing device is not receiving the charge is provided to a threshold number of times within a threshold duration of time.

9. The user computing device of any one of the preceding claims, wherein the output indicating the user computing device is not receiving the charge is maintained for a threshold duration of time irrespective of whether the user computing device makes a different determination regarding whether the user computing device is proximate to the charging device within the threshold duration of time.

10. The user computing device of any one of the preceding claims, wherein:
the one or more first sensors include one or more magnetometers, and
the one or more processors are configured to:
determine at least one magnitude value based on the one or more first signals,
determine whether the at least one magnitude value satisfies a threshold magnitude value, and
when the at least one magnitude value satisfies the threshold magnitude value, determining the user computing device is proximate to the charging device,
wherein, optionally, the at least one magnitude value includes a maximum magnitude value among a plurality of magnitude values sampled during a predetermined duration of time.

11. The user computing device of any one of the preceding claims, wherein:
the one or more first sensors include one or more magnetometers, and
the one or more processors are configured to:
determine at least one magnitude range value based on the one or more first signals, wherein the at least one magnitude range value includes a difference between a maximum magnitude value among a plurality of magnitude values sampled during a predetermined duration of time and a minimum magnitude value among the plurality of magnitude values sampled during the predetermined duration of time,
determine whether the at least one magnitude range value satisfies a threshold magnitude range value, and
when the at least one magnitude range value satisfies the threshold magnitude range value, determining the user computing device is proximate to the charging device.

12. The user computing device of any one of claims 1 to 10, wherein:
the one or more first sensors include one or more magnetometers configured to measure the magnetic field with respect to a plurality of axes, and
the one or more processors are configured to:
determine at least one magnitude range value for each of the plurality of axes based on the one or more first signals, wherein the at least one magnitude range value includes a difference between a maximum magnitude value among a plurality of magnitude values sampled during a predetermined duration of time and a minimum magnitude value among the plurality of magnitude values sampled during the predetermined duration of time,
determine whether at least one of the at least one magnitude range values determined for each of the plurality of axes satisfies a threshold magnitude range value, and
when at least one of the at least one magnitude range values determined for each of the plurality of axes satisfies the threshold magnitude range value, determining the user computing device is proximate to the charging device.

13. The user computing device of any one of claims 1 to 10, wherein:
the one or more first sensors include one or more magnetometers, and
the one or more processors are configured to:
determine magnitude values based on the one or more first signals over a predetermined duration of time,
determine, for each of a plurality of intervals of time over the predetermined duration of time, whether at least one magnitude value from each interval among the plurality of intervals satisfies a threshold magnitude value, and
when the threshold magnitude value is satisfied for a threshold number of intervals among the plurality of intervals, determining the user computing device is proximate to the charging device.

14. A computer-implemented method, comprising:
detecting, by one or more processors of a user computing device, whether the user computing device is receiving a charge from a charging device; and
when the user computing device is not receiving the charge:
outputting one or more first signals based on a magnetic field measured via one or more first sensors of the user computing device,
determining, based on the one or more first signals output by the one or more first sensors, whether the user computing device is proximate to the charging device, and
when the user computing device is determined, based on the one or more first signals output by the one or more first sensors, to be proximate to the charging device, providing an output indicating the user computing device is not receiving the charge.

15. A non-transitory computer-readable medium which stores instructions that are executable by one or more processors of a user computing device, the instructions comprising instructions to cause the one or more processors to perform operations, the operations including:
detecting whether the user computing device is receiving a charge from a charging device; and
when the user computing device is not receiving the charge:
receiving one or more first signals based on a magnetic field measured via one or more first sensors of the user computing device,
determining, based on the one or more first signals output by the one or more first sensors, whether the user computing device is proximate to the charging device, and
when the user computing device is determined, based on the one or more first signals output by the one or more first sensors, to be proximate to the charging device, providing an output indicating the user computing device is not receiving the charge.
